# EUROPEAN PATENT APPLICATION

(11) **EP 4 478 403 A1**
(43) Date of publication of application: **18.12.2024**
(21) Application number: 24152371.1
(22) Date of filing: 17.01.2024
(51) Int. Cl.: H01L 21/768, H01L 23/532, H01L 23/528, H01L 23/522

(54) **SEMICONDUCTOR DEVICE**

(30) Priority: 13.06.2023 KR 20230075672
(71) Applicant: Samsung Electronics Co., Ltd., Suwon-si, Gyeonggi-do 16677 (KR)
(72) Inventor: NAM, Seo Woo, 16677 Suwon-si, Gyeonggi-do (KR); LEE, Eui Bok, 16677 Suwon-si, Gyeonggi-do (KR)
(74) Representative: Kuhnen & Wacker Patent- und Rechtsanwaltsbüro PartG mbB

(57) **Abstract**

A semiconductor device includes a lower wiring structure, an upper interlayer insulating film on the lower wiring structure and including an upper wiring trench and an upper wiring structure in the upper wiring trench. The upper wiring structure includes an upper barrier structure, and an upper filling film on the upper barrier structure. The upper barrier structure includes side wall portions extending along side walls of the upper wiring trench, and a bottom portion extending along a bottom face of the upper wiring trench. The upper barrier structure includes an upper barrier film, and an upper liner film between the upper barrier film and the upper filling film. The side wall portions of the upper barrier structure include a two-dimensional material (2D material), and the bottom face of the upper barrier structure is free of the two-dimensional material.

## Description

### CROSS-REFERENCE TO RELATED APPLICATION

This application claims priority from Korean Patent Application No. 10-2023-0075672 filed on June 13, 2023, in the Korean Intellectual Property Office, and all the benefits accruing therefrom under 35 U.S.C. 119, the contents of which in its entirety are herein incorporated by reference.

### FIELD

The present disclosure relates to a semiconductor device and a method for fabricating the same, and more specifically, to a semiconductor device including wiring lines formed in a BEOL (Back-End-Of-Line) process, and a method for fabricating the same.

### BACKGROUND

With the rapid progress of down-scaling of semiconductor elements due to the development of electronic technology, there is demand for higher integration and lower power consumption of semiconductor chips. In order to cope with the demand for higher integration and lower power consumption of the semiconductor chips, the feature sizes of semiconductor devices continue to decrease.

As the feature size decreases, various research on stable connecting methods between wirings is being conducted.

### SUMMARY

Aspects of the present disclosure provide a semiconductor device capable of improving element performance and reliability.

Aspects of the present disclosure provide a method for fabricating a semiconductor device capable of improving element performance and reliability.

According to an aspect of the present disclosure, there is provided a semiconductor device comprising a lower wiring structure, an upper interlayer insulating film on the lower wiring structure and including an upper wiring trench therein, an upper wiring structure in the upper wiring trench and including an upper barrier structure, and an upper filling film on the upper barrier structure. The upper barrier structure includes side wall portions extending along side walls of the upper wiring trench, and a bottom portion extending along a bottom surface of the upper wiring trench. The upper barrier structure includes an upper barrier film, and an upper liner film between the upper barrier film and the upper filling film. The side wall portions of the upper barrier structure include a two-dimensional material (2D material), and the bottom portion of the upper barrier structure is free of the two-dimensional material.

According to another aspect of the present disclosure, there is provided a semiconductor device comprising a lower wiring structure, an upper interlayer insulating film on the lower wiring structure and including an upper wiring trench therein. An upper wiring structure is in the upper wiring trench, and includes an upper barrier film, and an upper filling film on the upper barrier film. The upper barrier film extends along side walls of the upper wiring trench, and does not extend along an interface between the upper wiring structure and the lower wiring structure. The upper barrier film includes a two-dimensional material (2D material).

According to still another aspect of the present disclosure, there is provided a semiconductor device comprising a lower wiring structure, and an upper wiring structure on the lower wiring structure and including an upper barrier film, a first upper liner film, and an upper filling film. The first upper liner film is between the upper barrier film and the upper filling film. The first upper liner film includes a first portion that is in contact with the lower wiring structure, and a second portion that extends away from the lower wiring structure. The upper barrier film extends along the second portion of the first upper liner film, and the first portion of the first upper liner film is free of the upper barrier film thereon. The upper barrier film includes tantalum sulfide, and the first upper liner film includes tantalum nitride.

According to another aspect of the present disclosure, there is provided a method for fabricating a semiconductor device comprising forming a lower wiring structure, forming an upper interlayer insulating film including an upper wiring trench therein on the lower wiring structure, where the upper wiring trench exposes the lower wiring structure, forming a selective suppression film on the lower wiring structure that is exposed by the upper wiring trench, forming an upper barrier film along side walls of the upper wiring trench responsive to forming the selective suppression film on the lower wiring structure, where the upper barrier film comprises a two-dimensional material and is not formed along a bottom surface of the upper wiring trench , removing the selective suppression film after forming the upper barrier film, after removing the selective suppression film, forming an upper liner film on the upper barrier film along the side walls and the bottom surface of the upper wiring trench and forming an upper filling film in the upper wiring trench and on the upper liner film.

However, aspects of the present disclosure are not restricted to those specifically set forth herein. The above and other aspects of the present disclosure will become more apparent to one of ordinary skill in the art to which the present disclosure pertains by referencing the detailed description of the present disclosure given below.

### BRIEF DESCRIPTION OF DRAWINGS

FIG. 1 is an example layout diagram for explaining a semiconductor device according to some embodiments.
FIG. 2 is an example cross-sectional view taken along A-A of FIG. 1.
FIG. 3 is an example cross-sectional view taken along B-B of FIG. 1.
FIG. 4 is an enlarged view of a portion P of FIG. 2.
FIG. 5 is a diagram for explaining the shape of a first upper liner film of FIG. 4.
FIGS. 6, 7, and 8 are diagrams for explaining a semiconductor device according to some embodiments.
FIG. 9 is a diagram for explaining a semiconductor device according to some embodiments.
FIGS. 10 and 11 are diagrams for explaining the semiconductor device according to some embodiments.
FIGS. 12 and 13 are diagrams for explaining the semiconductor device according to some embodiments, respectively.
FIGS. 14, 15, 16, and 17 are diagrams for explaining a semiconductor device according to some embodiments.
FIG. 18 is a diagram for explaining a semiconductor device according to some embodiments.
FIG. 19 is a diagram for explaining a semiconductor device according to some embodiments.
FIGS. 20, 21, and 22 are diagrams for explaining a semiconductor device according to some embodiments.
FIG. 23 is a diagram for explaining a semiconductor device according to some embodiments.
FIGS. 24, 25, and 26 are diagrams for explaining a semiconductor device according to some embodiments, respectively.
FIGS. 27, 28, 29, 30, 31, and 32 are intermediate step diagrams for describing a method for fabricating the semiconductor device according to some embodiments.

### DETAILED DESCRIPTION OF EMBODIMENTS

Although terms such as first and second are used to describe various elements or components in the present specification, it goes without saying that these elements or components are not limited by these terms. These terms are only used to distinguish a single element or component from other elements or components. Therefore, that a first element or component referred to below may be a second element or component within the technical idea of the present disclosure. That is, the terms "first," "second," etc., may be used herein merely to distinguish one component, layer, direction, etc. from another. The terms "comprises," "comprising," "includes" and/or "including," when used herein, specify the presence of stated elements, but do not preclude the presence of additional elements. The term "and/or" includes any and all combinations of one or more of the associated listed items. Similarly, the phrase "at least one of A, B, and C" refers to any and all combinations of one or more of A or B or C, and should not be construed to mean "at least one of A, at least one of B and at least one of C."

Although drawings of a semiconductor device according to some example embodiments show a fin-like transistor (FinFET) including a channel region of a fin-like pattern shape, a transistor including nanowire or nanosheet, a MBCFET^{™} (Multi-Bridge Channel Field Effect Transistor) or a vertical transistor (Vertical FET), the present disclosure is not limited thereto. The semiconductor device according to some embodiments may include a tunneling transistor (tunneling FET) or a three-dimensional (3D) transistor. The semiconductor device according to some embodiments may include a planar transistor. In addition, the technical idea of the present disclosure may be applied to a transistor based on two-dimensional material (2D material based FETs) and a heterostructure thereof.

Further, the semiconductor device according to some embodiments may also include a bipolar junction transistor, a laterally diffused metal oxide semiconductor (LDMOS), or the like.

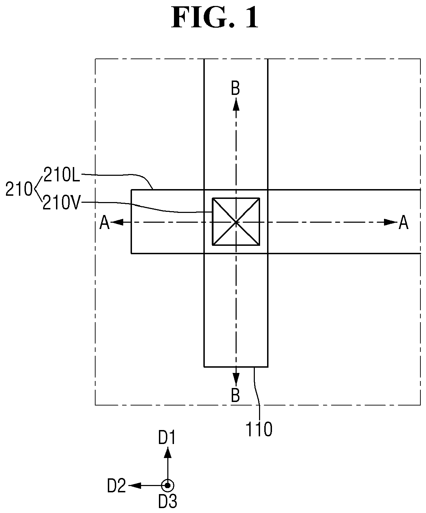

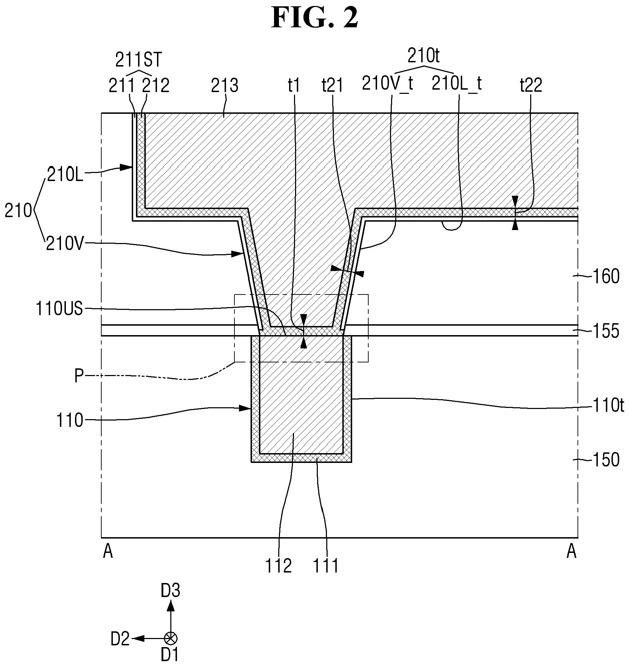

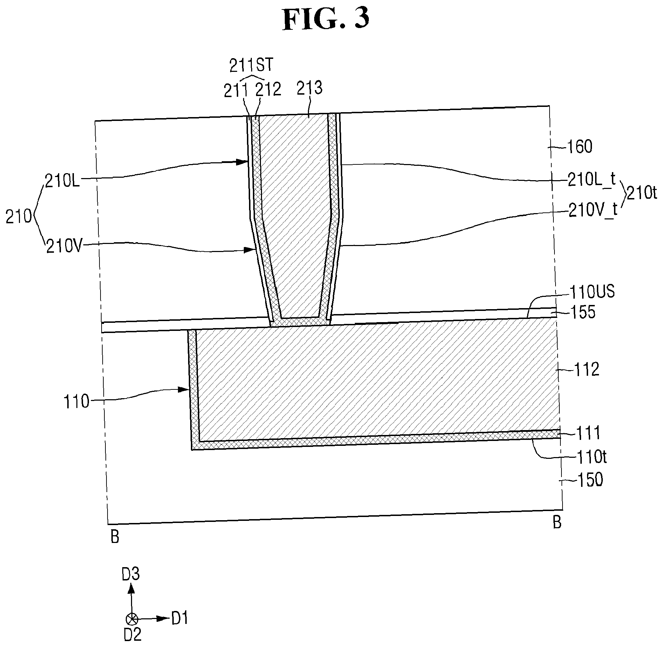

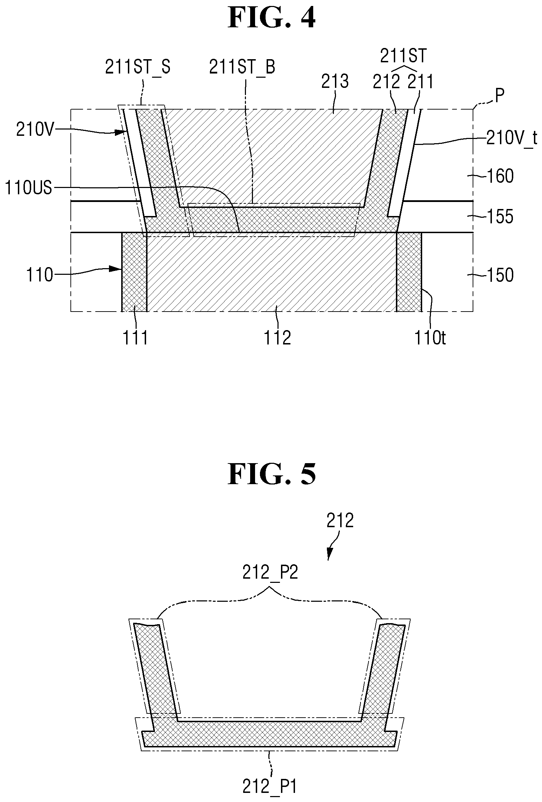

FIG. 1 is an example layout diagram for explaining a semiconductor device according to some embodiments. FIG. 2 is an example cross-sectional view taken along A-A of FIG. 1. FIG. 3 is an example cross-sectional view taken along B-B of FIG. 1. FIG. 4 is an enlarged view of a portion P of FIG. 2. FIG. 5 is a diagram for explaining the shape of a first upper liner film of FIG. 4.

Referring to FIGS. 1 to 5, the semiconductor device according to some embodiments may include a first lower wiring structure 110 and a first upper wiring structure 210.

The first lower wiring structure 110 may be disposed inside the first interlayer insulating film 150. The first lower wiring structure 110 may extend, for example, in a first direction D1.

The first lower wiring structure 110 may have a linear or line shape extending in the first direction D1. For example, the first direction D1 may be a longitudinal direction of the first lower wiring structure 110, and the second direction D2 may be a width direction of the first lower wiring structure 110. Here, the first direction D1 intersects the second direction D2 and the third direction D3. The second direction D2 intersects the third direction D3.

The first interlayer insulating film 150 may cover a source/drain of a transistor formed in a FEOL (front-end-of-line) process. Alternatively, the first interlayer insulating film 150 may be an interlayer insulating film formed in a BEOL (back-end-of-line) process.

In other words, as an example, the first lower wiring structure 110 may be a contact or contact wiring formed in a MOL (middle-of-line) process. As another example, the first lower wiring structure 110 may be a connection wiring formed in the BEOL (back-end-of-line) process.

The first interlayer insulating film 150 may include, for example, at least one of silicon oxide, silicon nitride, silicon oxynitride and a low dielectric constant material. The low dielectric constant material may be, for example, silicon oxide having moderately high carbon and hydrogen, and may be a material such as SiCOH. On the other hand, since carbon is included in the insulating material, the dielectric constant of the insulating material may be lowered. However, in order to further lower the dielectric constant of the insulating material, the insulating material may include a pore such as a cavity in which gas or air is filled in the insulating material.

The low dielectric constant material may include, for example, but is not limited to, Fluorinated TetraEthylOrthoSilicate (FTEOS), Hydrogen SilsesQuioxane (HSQ), Bis-benzoCycloButene (BCB), TetraMethylOrthoSilicate (TMOS), OctaMethyleyCloTetraSiloxane (OMCTS), HexaMethylDiSiloxane (HMDS), TriMethylSilyl Borate (TMSB), DiAcetoxyDitertiaryButoSiloxane (DADBS), TriMethylSilil Phosphate (TMSP), PolyTetraFluoroEthylene (PTFE), TOSZ (Tonen SilaZen), FSG (Fluoride Silicate Glass), polyimide nanofoams such as polypropylene oxide, CDO (Carbon Doped silicon Oxide), OSG (Organo Silicate Glass), SiLK, Amorphous Fluorinated Carbon, silica aerogels, silica xerogels, mesoporous silica or combinations thereof.

For example, if the first lower wiring structure 110 is a connection wiring formed in the BEOL process, the first lower wiring structure 110 may be disposed at a first metal level. The first interlayer insulating film 150 may include a first lower wiring trench 1 10t extending longitudinally in the first direction D1.

The first lower wiring structure 110 may be disposed inside the first lower wiring trench 110t. The first lower wiring structure 110 fills the first lower wiring trench 110t.

The first lower wiring structure 110 may include a lower barrier film 111 and a lower filling film 112. The lower barrier film 111 may extend along side walls and a bottom face of the first lower wiring trench 110t.

The lower filling film 112 may be disposed on the lower barrier film 111. The lower filling film 112 may fill the rest of the first lower wiring trench 1 10t. The terms "surround" or "cover" or "fill," as may be used herein, may not require completely surrounding or covering or filling the described elements or layers, but may, for example, refer to partially surrounding or covering or filling the described elements or layers, for example, with voids or other spaces throughout.

The lower barrier film 111 may include a conductive material. The lower barrier film 111 may include, for example, at least one of tantalum (Ta), tantalum nitride (TaN), tantalum nitride (TaN:Ru) doped with ruthenium (Ru), titanium (Ti), titanium nitride (TiN), titanium silicon nitride (TiSiN), tungsten nitride (WN), tungsten carbonitride (WCN), ruthenium (Ru), cobalt (Co), ruthenium-cobalt (RuCo) alloy, zirconium (Zr), zirconium nitride (ZrN), vanadium (V), vanadium nitride (VN), niobium (Nb), niobium nitride (NbN), platinum (Pt), iridium (Ir), rhodium (Rh) and a two-dimensional material (2D material). The lower barrier film 111 is shown as being a single film, but is not limited thereto. The lower barrier film 111 may include a plurality of conductive films, in contrast to the shown example.

The lower filling film 112 includes a conductive material, and may include, for example, at least one of aluminum (Al), copper (Cu), tungsten (W), cobalt (Co), ruthenium (Ru), silver (Ag), gold (Au), manganese (Mn), molybdenum (Mo), rhodium (Rh), iridium (Ir), RuAl, NiAl, NbB₂, MoB₂, TaB₂, V₂AlC and CrAlC.

An upper face or surface 110US of the first lower wiring structure may be defined by the lower barrier film 111 and the lower filling film 112. In contrast to the shown example, the first lower wiring structure 110 may have a single film structure. Although not shown, it may further include a via pattern that connects the conductive pattern disposed under the first lower wiring structure 110.

The first lower wiring structure 110 may be formed using, for example, a damascene method. Although the width of the first lower wiring structure 110 in the second direction D2 is shown as being constant in FIG. 2, the present disclosure is not limited thereto. In contrast to the shown example, the width of the first lower wiring structure 110 in the second direction D2 may decrease, as it goes away from the upper face of the first interlayer insulating film 150.

A first etching stop film 155 may be disposed on the first lower wiring structure 110 and the first interlayer insulating film 150. A second interlayer insulating film 160 may be disposed on the first etching stop film 155. The first etching stop film 155 may be disposed between the first interlayer insulating film 150 and the second interlayer insulating film 160.

The second interlayer insulating film 160 may include a first upper wiring trench 210t. The first upper wiring trench 210t may pass through the first etching stop film 155. The first upper wiring trench 210t may expose a part of the first lower wiring structure 110. The term "exposed," may be used to describe relationships between elements and/or certain intermediate processes in fabricating a completed semiconductor device, but is not intended to necessarily require exposure of the particular region, layer, structure or other element in the completed device.

The first upper wiring trench 210t may include an upper via trench 210V_t, and a first upper wiring line trench 210L_t. For example, the first upper wiring line trench 210L_t may extend longitudinally in the second direction D2. The first upper wiring line trench 210L_t may extend up to the upper face of the second interlayer insulating film 160. The upper via trench 210V_t may be formed on the bottom face or surface of the first upper wiring line trench 210L_t.

For example, the bottom face of the first upper wiring trench 210t may be a bottom face of the upper via trench 210V_t. The bottom face of the first upper wiring trench 210t may be defined by the first lower wiring structure 110.

The side walls of the first upper wiring trench 210t may include side walls and bottom face of the first upper wiring line trench 210L_t, and side walls of the upper via trenches 210V_t. The side walls and bottom face of the first upper wiring line trench 210L_t may be defined by the second interlayer insulating film 160. The side walls of the upper via trench 210V_t may be defined by the second interlayer insulating film 160 and the first etching stop film 155.

The second interlayer insulating film 160 may include, for example, at least one of silicon oxide, silicon nitride, silicon oxynitride, and a low dielectric constant material.

The first etching stop film 155 may include a material having an etching selectivity with respect to the second interlayer insulating film 160. The first etching stop film 155 may include, for example, at least one of silicon nitride (SiN), silicon oxynitride (SiON), silicon oxycarbonitride (SiOCN), silicon boron nitride (SiBN), silicon oxyboron nitride (SiOBN), silicon oxycarbide (SiOC), aluminum oxide (AlO), aluminum nitride (AlN), aluminum oxycarbide (AlOC), and combinations thereof.

Although the first etching stop film 155 is shown as a single film, this is only for convenience of explanation, and the embodiment is not limited thereto. Needless to say, in contrast to the shown example, the first etching stop film 155 may include a plurality of insulating films sequentially stacked on the first interlayer insulating film 150.

The first upper wiring structure 210 may be disposed inside the first upper wiring trench 210t. The first upper wiring structure 210 may fill the first upper wiring trench 210t. The first upper wiring structure 210 may be disposed in the second interlayer insulating film 160.

The first upper wiring structure 210 is disposed on the first lower wiring structure 110. The first upper wiring structure 210 is connected to the first lower wiring structure 110. The first upper wiring structure 210 is in contact with the first lower wiring structure 110 along the interface (e.g., 110US).

The first upper wiring structure 210 may include a first upper wiring line 210L and an upper via 210V. The upper via 210V connects the first upper wiring line 210L and the first lower wiring structure 110. The terms "connects" or "connected" may be used herein to refer to a physical and/or electrical connection. The upper via 210V may be in contact with the first lower wiring structure 110. As used herein, when components or layers are referred to as "directly" on or connected or contacting, no intervening components or layers are present.

For example, the upper face 110US of the first lower wiring structure may include a first region that is in contact with the first upper wiring structure 210, and a second region that is not in contact with the first upper wiring structure 210. The upper via 210V is in contact with a first region of the upper face 110US of the first lower wiring structure.

The first upper wiring structure 210 fills the upper via trench 210V_t and the first upper wiring line trench 210L_t. The first upper wiring line 210L is disposed in the first upper wiring line trench 210L_t. The upper via 210V is disposed in the upper via trench 210V_t.

If the first lower wiring structure 110 is a connection wiring formed in the BEOL process, the first upper wiring line 210L may be disposed at a second metal level different from the first metal level. The first upper wiring line 210L is disposed in the second metal level higher than the first metal level. If the first lower wiring structure 110 is a conductive contact formed in the MOL process, the first upper wiring line 210L may be disposed at the lowest metal level among the metal levels included in the BEOL process.

The first upper wiring structure 210 includes a first upper barrier structure 211ST and a first upper filling film 213. The first upper filling film 213 is disposed on the first upper barrier structure 211ST. The first upper barrier structure 21 1ST includes a first upper barrier film 211 and a first upper liner film 212. Although not shown, the first upper wiring structure 210 may include an upper capping film extending along the upper face of the first upper filling film 213.

The first upper barrier structure 211ST may extend along the side walls and bottom face of the first upper wiring trench 210t. The first upper barrier structure 211ST may include side wall portions 211ST_S and a bottom portion 211ST_B.

The side wall portions 211ST_S of the first upper barrier structure extend along side walls and bottom face of the first upper wiring line trench 210L_t and side walls of the upper via trench 210V_t. The bottom portion 211 ST_B of the first upper barrier structure extends along the bottom face of the upper via trench 210V_t.

The first upper barrier film 211 extends along side walls of the first upper wiring trench 210t. The first upper barrier film 211 does not extend along the bottom face of the first upper wiring trench 210t. The first upper barrier film 211 is in contact with the second interlayer insulating film 160. The first upper barrier film 211 may not cover the first lower wiring structure 110 exposed by the upper via trench 210V_t.

The first upper barrier film 211 extends along side walls and bottom face of the first upper wiring line trench 210L_t and side walls of the upper via trench 210V_t. The first upper barrier film 211 may not extend up to the lower wiring structure 110 that defines the bottom face of the first upper wiring trench 210t.

In the semiconductor device according to some embodiments, the first upper barrier film 211 does not extend up to the upper face 110US of the first lower wiring structure 110. That is, a portion or entirety of the interface (e.g., 110US) between the lower wiring structure 110 and the upper wiring structure 210 may be free of the first upper barrier film 211. The first upper barrier film 211 may extend along a part of the side walls of the upper via trench 210V_t. The first upper barrier film 211 may not be in direct contact with the first lower wiring structure 110. For example, the first upper barrier film 211 may not extend along at least part of the interface between the lower wiring structure 110 and the upper wiring structure 210.

The first upper barrier film 211 includes a conductive material, and may include, for example, a two-dimensional material. For example, the first upper barrier film 211 may be formed of a two-dimensional material. The two-dimensional material (2D material) may include a 2D allotrope or a 2D compound, and may include, for example, but not limited to, at least one of graphene, boron nitride (BN), molybdenum sulfide, molybdenum selenide, tungsten sulfide, tungsten sulfide, and tantalum sulfide. That is, since the above-mentioned 2D materials are only listed by way of example, the 2D materials that may be included in the semiconductor device of the present disclosure are not limited by the above-mentioned materials.

In the semiconductor device according to some embodiments, the first upper barrier film 211 may include tantalum sulfide, which is a two-dimensional material. As an example, the first upper barrier film 211 may be formed of tantalum sulfide, which is a two-dimensional material. As another example, the first upper barrier film 211 may be in a state in which tantalum sulfide, which is a two-dimensional material, is doped with ruthenium (Ru).

The first upper liner film 212 is disposed on the first upper barrier film 211. The first upper liner film 212 is disposed between the first upper barrier film 211 and the first upper filling film 213. For example, the first upper liner film 212 may be in contact with the first upper barrier film 211.

The first upper liner film 212 extends along side walls and a bottom face of the first upper wiring trench 210t. The first upper liner film 212 extends along side walls and bottom face of the first upper wiring line trenches 210L_t, and side walls and bottom face of the first upper via trench 210V_t.

The first upper liner film 212 is in contact with the first lower wiring structure 110. The first upper liner film 212 is in contact with the upper face 110US of the first lower wiring structure 110. The first upper liner film 212 extends along the upper face 110US of the first lower wiring structure 110.

Since the first upper barrier film 211 is not in contact with the first lower wiring structure 110, a part of the first upper liner film 212 may be inserted between the upper face 110US of the first lower wiring structure and the lowest part of the first upper barrier film 211, e.g., along the interface 110US. As in FIG. 4, the first upper barrier film 211 may sit on the first upper liner film 212 such that the first upper liner film 212 separates the first upper barrier film 211 from the upper face 110US of the first lower wiring structure 110, and separates the first upper barrier film 211 from the first upper filling film 213. In contrast to the shown example, the first upper liner film 212 may not be inserted or may not extend between the upper face 110US of the first lower wiring structure and the lowest part of the first upper barrier film 211.

The first upper liner film 212 may be in contact with the first etching stop film 155 that defines side walls of the first upper wiring trench 210t. In contrast to the shown example, the first upper liner film 212 may not be in contact with the first etching stop film 155 that defines the side walls of the first upper wiring trench 210t.

The first upper liner film 212 may include a conductive material, and may include at least one of tantalum (Ta), tantalum nitride (TaN), tantalum nitride (TaN:Ru) doped with ruthenium (Ru), titanium (Ti), titanium nitride (TiN), titanium silicon nitride (TiSiN), tungsten nitride (WN), tungsten carbonitride (WCN), ruthenium (Ru), cobalt (Co), ruthenium-cobalt (RuCo) alloy, zirconium (Zr), zirconium nitride (ZrN), vanadium (V), vanadium nitride (VN), niobium (Nb), niobium nitride (NbN), platinum (Pt), iridium (Ir), and rhodium (Rh).

As an example, the first upper liner film 212 may include metal nitride. The first upper liner film 212 may include, for example, one of tantalum nitride (TaN) and tantalum nitride (TaN) doped with ruthenium (Ru).

As another example, the first upper liner film 212 may include one of cobalt (Co) and ruthenium-cobalt (RuCo). Here, "ruthenium-cobalt" may be a metal formed purely of ruthenium and cobalt, or may be a metal containing impurities introduced during the process of forming the first upper liner film 212. Here, "ruthenium-cobalt" may be in the form of an alloy made of ruthenium and cobalt, or may be in the form of cobalt (Co) doped with ruthenium (Ru).

For example, a thickness t21 of the first upper liner film 212 at the side wall of the upper via trench 210V_t may be the same as a thickness t1 of the first upper liner film 212 at the upper face 110US of the first lower wiring structure. The thickness t21 of the first upper liner film 212 at the side wall of the upper via trench 210V_t may be the same as a thickness t22 of the first upper liner film 212 at the bottom face of the first upper wiring line trench 210L_t.

In FIGS. 2 and 4, the side wall portion 211ST_S of the first upper barrier structure 211ST may include a first upper barrier film 211 and a first upper liner film 212. The bottom portion 211 ST_B of the first upper barrier structure 211 ST includes the first upper liner film 212, and does not include the first upper barrier film 211.

The side wall portion 211ST_S of the first upper barrier structure 211ST includes a two-dimensional material. The bottom portion 211 ST_B of the first upper barrier structure 211 ST (e.g., along 110US) does not include the two-dimensional material.

In FIGS. 2, 4 and 5, the first upper liner film 212 may include a first portion 212_P1 that is in contact with the first lower wiring structure 110, and a second portion 212_P2 that is not in contact with the first lower wiring structure 110. In the semiconductor device according to some embodiments, the first portion 212_P1 of the first upper liner film may extend along the bottom face of the first upper wiring trench 210t. The second portion 212_P2 of the first upper liner film may extend along side walls of the first upper wiring trench 210t.

The first upper barrier film 211 does not extend along the first portion 212_P1 of the first upper liner film. The first upper barrier film 211 is not disposed along the boundary or interface between the first portion 212_P1 of the first upper liner film and the first lower wiring structure 110. The first upper barrier film 211 may extend along the second portion 212_P2 of the first upper liner film.

The first upper filling film 213 is disposed on the first upper liner film 212. The first upper filling film 213 may be in contact with the first upper liner film 212. The first upper filling film 213 may fill the rest of the first upper wiring trench 210t.

The first upper liner film 212 is disposed between the first upper filling film 213 and the first lower wiring structure 110. The first upper filling film 213 may not be in contact with the first lower wiring structure 110.

The first upper filling film 213 includes a conductive material, and may include, for example, at least one of aluminum (Al), copper (Cu), tungsten (W), cobalt (Co), ruthenium (Ru), silver (Ag), gold (Au), manganese (Mn), molybdenum (Mo), rhodium (Rh), iridium (Ir), RuAl, NiAl, NbB₂, MoB₂, TaB₂, V₂AlC, and CrAlC.

When the first upper barrier film 211 is formed of a two-dimensional material, the thickness of the first upper barrier film 211 may get thin. Even if the thickness of the first upper barrier film 211 is thin, the first upper barrier film 211 may effectively reduce or prevent the diffusion of materials contained in the first upper filling film 213 or the like. Since the volume of the first upper barrier film 211 in the first upper wiring trench 210t decreases, a sufficient space for forming the first upper filling film 213 may be secured. Therefore, the resistance value of the first upper wiring structure 210 may be reduced.

In addition, since the resistance of the two-dimensional material is low in an in-plane direction, the first upper barrier film 211 may contribute to reducing the resistance of the first upper wiring structure 210.

However, the resistance of two-dimensional material in an out-of-plane direction may be high. For example, the out-of-plane direction of the two-dimensional material may be the third direction D3 in which the first lower wiring structure 110 and the first upper wiring structure 210 are in contact with each other. The first upper barrier film 211 formed of a two-dimensional material is not disposed at the boundary portion or interface in which the first lower wiring structure 110 and the first upper wiring structure 210 are in contact with each other. That is, the resistance between the first lower wiring structure 110 and the first upper wiring structure 210 may decrease. Therefore, the reliability and performance of the semiconductor device can be improved or enhanced.

When the first upper filling film 213 and the lower filling film 112 are in contact with each other, an electromigration (EM) characteristics may be degraded. However, since the first upper liner film 212 is disposed between the first upper filling film 213 and the first lower wiring structure 110, the first upper filling film 213 and the lower filling film 112 are not in contact with each other. That is, electromigration characteristics between the first lower wiring structure 110 and the first upper wiring structure 210 are not degraded. Therefore, the reliability and performance of the semiconductor device can be improved or enhanced.

Although the first lower wiring structure 110 is shown as having a conductive film stack structure with the first upper wiring structure 210, the embodiment is not limited thereto. In contrast to the shown example, the first lower wiring structure 110 may have the same conductive film stack structure as the first upper wiring structure 210.

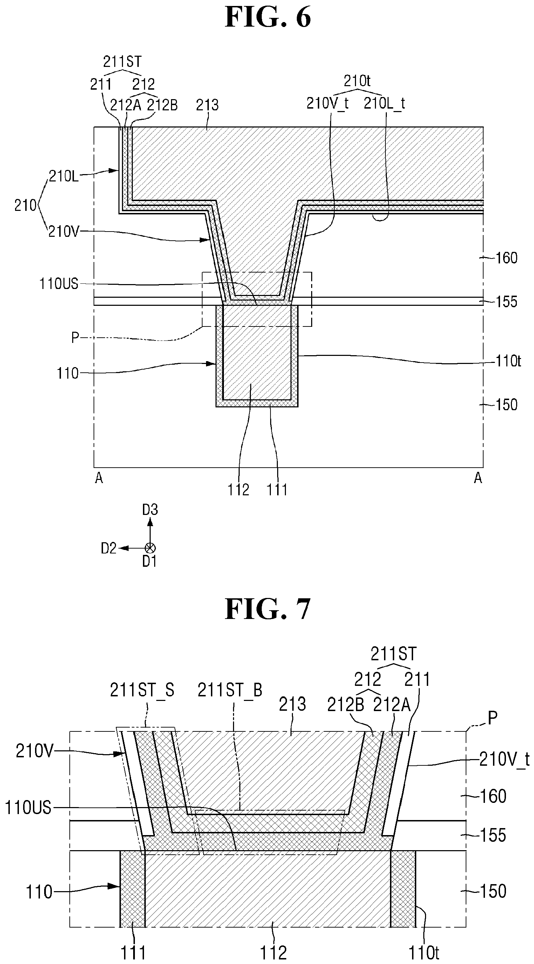

FIGS. 6 to 8 are diagrams for explaining a semiconductor device according to some embodiments. For convenience of explanation, the explanation will focus on points that are different from those explained using FIGS. 1 to 5.

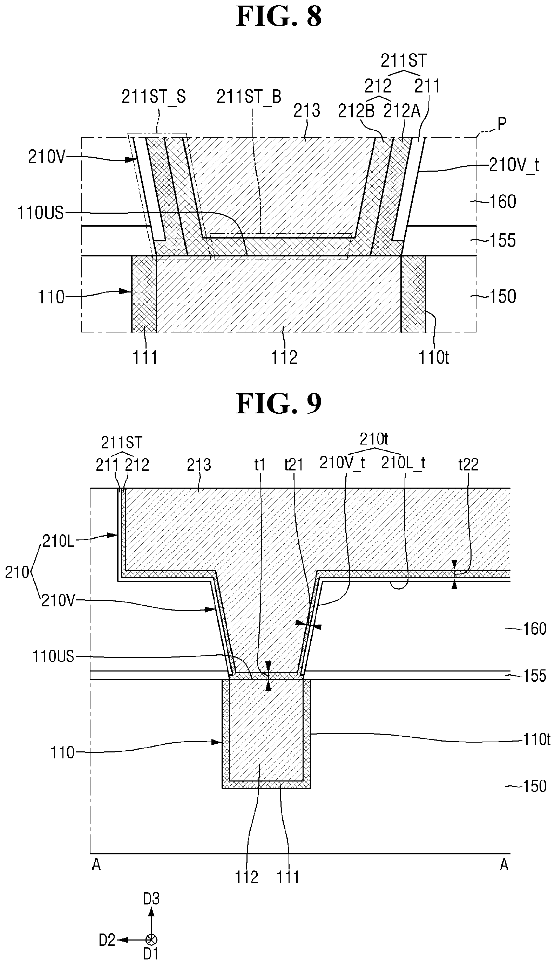

For reference, FIGS. 7 and 8 are enlarged views of a portion P of FIG. 6.

Referring to FIGS. 6 to 8, in the semiconductor device according to some embodiments, the first upper liner film 212 may include a plurality of conductive films.

The first upper liner film 212 may include a first sub-upper liner film 212A and a second sub-upper liner film 212B. The first sub-upper liner film 212A may be disposed between the first upper barrier film 211 and the second sub-upper liner film 212B. The second sub-upper liner film 212B may be disposed between the first upper filling film 213 and the first sub-upper liner film 212A.

The first sub-upper liner film 212A may be in contact with the first upper barrier film 211. The second sub-upper liner film 212B may be in contact with the first upper filling film 213.

The first sub-upper liner film 212A may include metal nitride. The first sub-upper liner film 212A may include, for example, one of tantalum nitride (TaN) and tantalum nitride (TaN:Ru) doped with ruthenium (Ru). The second sub-upper liner film 212B may include one of cobalt (Co) and ruthenium-cobalt (RuCo).

In FIG. 7, the first sub-upper liner film 212A and the second sub-upper liner film 212B may each extend along side walls and a bottom face of the first upper wiring trench 210t. The first sub-upper liner film 212A may be in contact with the upper face 110US of the first lower wiring structure. The second sub-upper liner film 212B may not be in contact with the upper face 110US of the first lower wiring structure.

The side wall portion 211ST_S of the first upper barrier structure may include a first upper barrier film 211, a first sub-upper liner film 212A, and a second sub-upper liner film 212B. The bottom portion 211 ST_B of the first upper barrier structure includes the first sub-upper liner film 212A and the second sub-upper liner film 212B, but does not include the first upper barrier film 211.

Since the first upper barrier film 211 is not in contact with the first lower wiring structure 110, a part of the first sub-upper liner film 212A may be inserted between the upper face 110US of the first lower wiring structure and the lowest part of the first upper barrier film 211. In contrast to the shown example, the first sub-upper liner film 212A may not be inserted between the upper face 1 10US of the first lower wiring structure and the lowest part of the first upper barrier film 211.

The first sub-upper liner film 212A may be in contact with the first etching stop film 155 that defines side walls of the first upper wiring trench 210t. In contrast to the shown example, the first sub-upper liner film 212A may not be in contact with the first etching stop film 155 that defines the side walls of the first upper wiring trench 210t.

In FIG. 8, the second sub-upper liner film 212B may each extend along side walls and bottom face of the first upper wiring trench 210t. The first sub-upper liner film 212A may extend along the side walls of the first upper wiring trench 210t. The first sub-upper liner film 212A may not extend along (or may extend along less than an entirety of) the bottom face of the first upper wiring trench 210t. The first sub-upper liner film 212A may be in contact with the upper face 110US of the first lower wiring structure 110, for example, at edge portions thereof. The second sub-upper liner film 212B may be in contact with the upper face 110US of the first lower wiring structure 110, for example, at central portions thereof.

The side wall portion 211ST_S of the first upper barrier structure may include a first upper barrier film 211, a first sub-upper liner film 212A, and a second sub-upper liner film 212B. The bottom portion 211ST_B of the first upper barrier structure includes the second sub-upper liner film 212B, but does not include the first upper barrier film 211 and the first sub-upper liner film 212A.

In contrast to the shown example, the first sub-upper liner film 212A may not be in contact with the upper face 1 10US of the first lower wiring structure. The first sub-upper liner film 212A may not be in contact with the first etching stop film 155 that defines the side walls of the first upper wiring trench 210t.

In contrast to the shown example, a part of the second sub-upper liner film 212B may be inserted between the upper face 110US of the first lower wiring structure and the lowest part of the first upper barrier film 211.

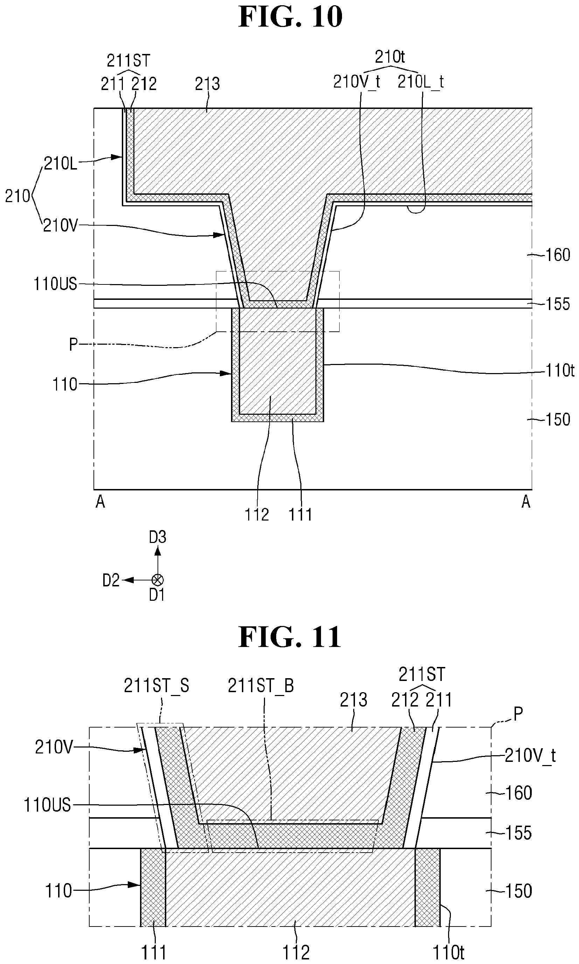

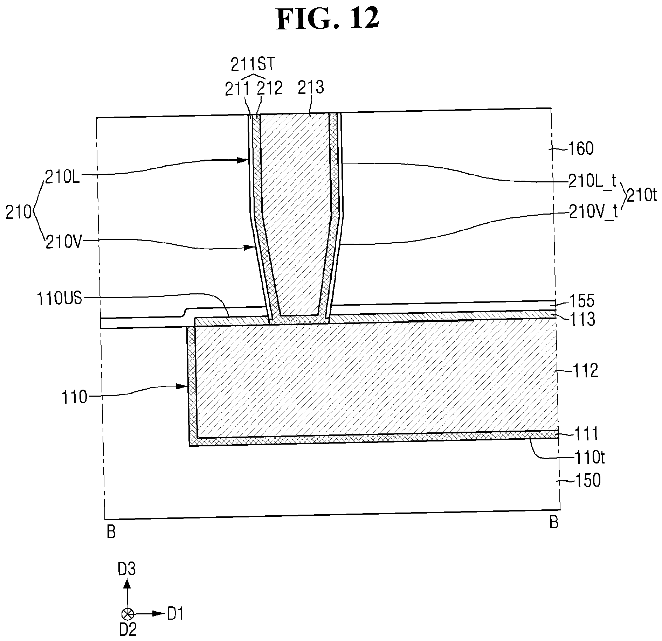

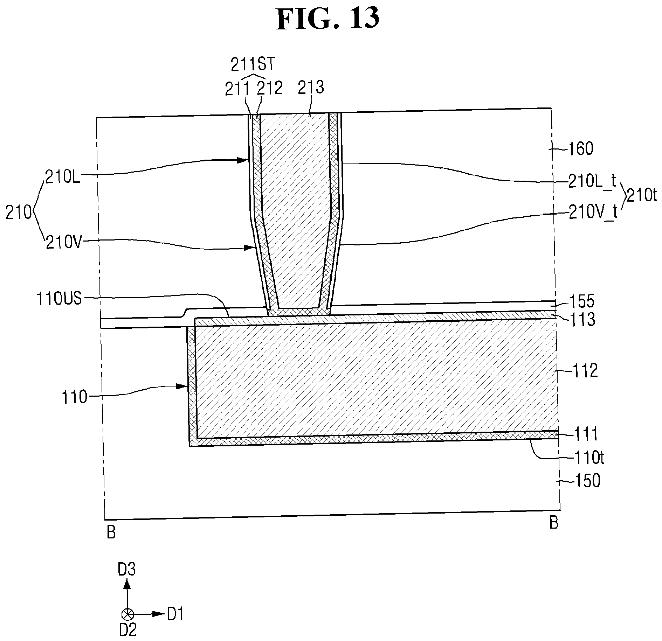

FIG. 9 is a diagram for explaining a semiconductor device according to some embodiments. FIGS. 10 and 11 are diagrams for explaining the semiconductor device according to some embodiments. FIGS. 12 and 13 are diagrams for explaining the semiconductor device according to some embodiments, respectively. For convenience of explanation, the explanation will focus on points that are different from those explained using FIGS. 1 to 5.

For reference, FIG. 11 is an enlarged view of a portion P of FIG. 10.

Referring to FIG. 9, in the semiconductor device according to some embodiments, a thickness t21 of the first upper liner film 212 on the side wall of the upper via trench 210V_t is smaller than a thickness t1 of the first upper liner film 212 on the upper face 110US of the first lower wiring structure.

The thickness t21 of the first upper liner film 212 at the side wall of the upper via trench 210V_t is smaller than a thickness t22 of the first upper liner film 212 at the bottom face of the first upper wiring line trench 210L_t.

Referring to FIGS. 10 and 11, in the semiconductor device according to some embodiments, the first upper barrier film 211 may extend up to the first lower wiring structure 110 that defines a bottom face of the first upper wiring trench 210t, that is, at least partially along the interface between the first lower wiring structure 110 and the first upper wiring structure 210.

The first upper barrier film 211 may be in contact with the first lower wiring structure 110, e.g., at edge portions thereof. The first upper barrier film 211 may extend up to the upper face 110US of the first lower wiring structure.

The first upper barrier film 211 does not include a portion extending along the upper face 110US of the first lower wiring structure. For example, the first upper barrier film 211 on the side wall of the upper via trench 210V_t may have an "I" shape instead of an "L" shape.

Referring to FIGS. 12 and 13, in the semiconductor device according to some embodiments, the first lower wiring structure 110 may further include a lower capping film 113 extending along the upper face of the lower filling film 112.

The lower capping film 113 may extend along the upper face of the lower filling film 112. The lower capping film 113 may not cover the upper face of the lower barrier film 111. In contrast to the shown example, the lower capping film 113 may cover the upper face of the lower barrier film 111.

The lower capping film 113 includes a conductive material, and may include, for example, metal. The lower capping film 113 may include, for example, cobalt (Co).

In FIG. 12, the lower capping film 113 may be removed from or may otherwise not be present on the portion of the first lower wiring structure 110 that is connected to the first upper wiring structure 210. The first upper wiring structure 210 may be in direct contact with the exposed lower filling film 112. The upper face 110US of the first lower wiring structure may be defined by the lower filling film 112 and the lower capping film 113.

In FIG. 13, the lower capping film 113 is not removed from the portion of the first lower wiring structure 110 that is connected to the first upper wiring structure 210. The first upper wiring structure 210 may be in contact with the lower capping film 113. The lower filling film 112 may not be in direct contact with the first upper wiring structure 210. The upper face 110US of the first lower wiring structure may be defined by the lower capping film 113.

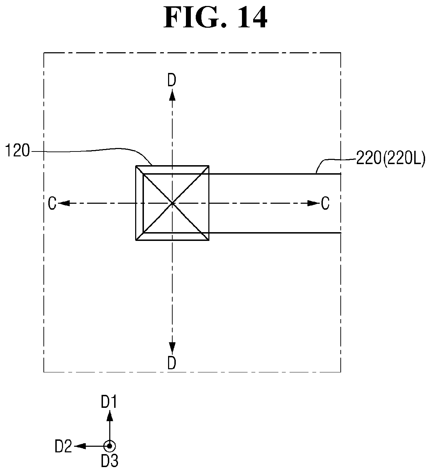

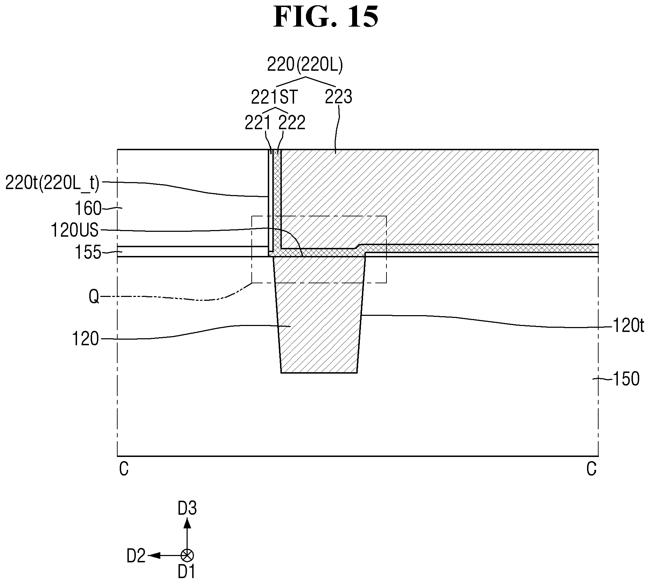

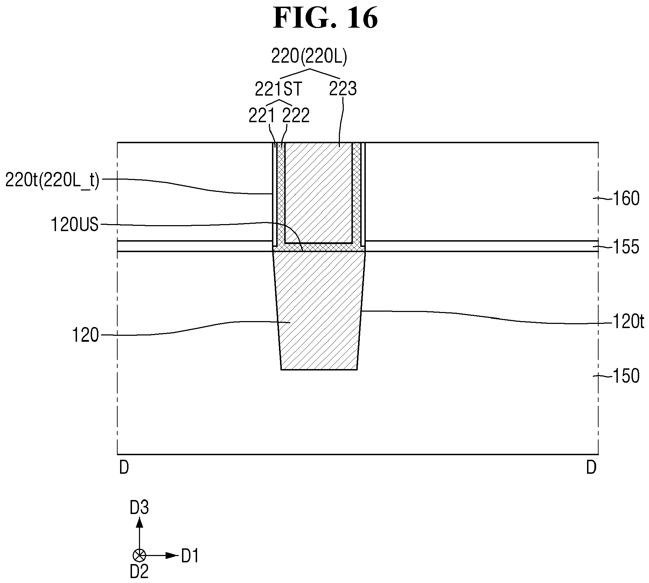

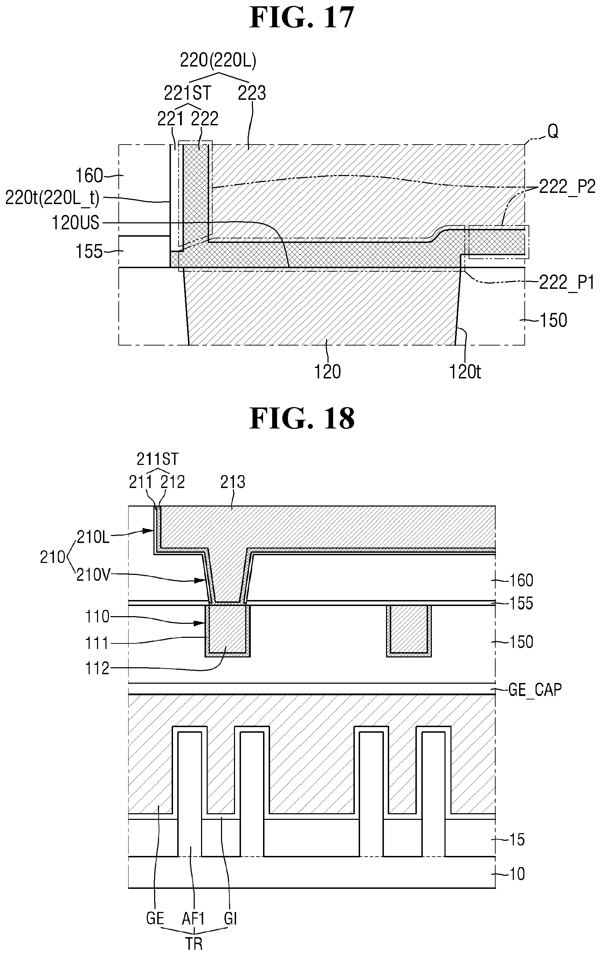

FIGS. 14 to 17 are diagrams for explaining a semiconductor device according to some embodiments. For reference, FIG. 14 is an example layout diagram for describing the semiconductor device according to some embodiments. FIG. 15 is an example cross-sectional view taken along C-C of FIG. 14. FIG. 16 is an example cross-sectional view taken along D-D of FIG. 14. FIG. 17 is an enlarged view of a portion Q of FIG. 15.

Referring to FIGS. 14 to 17, the semiconductor device according to some embodiments may include a second lower wiring structure 120 and a second upper wiring structure 220.

The second lower wiring structure 120 may be disposed inside the first interlayer insulating film 150. The second lower wiring structure 120 may have a contact shape.

As an example, the second lower wiring structure 120 may be a contact formed in the MOL process. As another example, the second lower wiring structure 120 may be a via included in the connection wiring formed in the BEOL process.

The first interlayer insulating film 150 may include a second lower wiring trench 120t. The second lower wiring structure 120 may be disposed inside the second lower wiring trench 120t. The second lower wiring structure 120 fills the second lower wiring trench 120t.

The second lower wiring structure 120 may have a single conductive film structure. The second lower wiring structure 120 may include metal capable of being selectively grown on the conductive material. The second lower wiring structure 120 may include, for example, but not limited to, one of titanium (Ti), tungsten (W), molybdenum (Mo), ruthenium (Ru), and cobalt (Co). In contrast to the shown example, the second lower wiring structure 120 may have multiple conductive film structures including a lower barrier film and a lower filling film, like the first lower wiring structure 110.

The second interlayer insulating film 160 may include a second upper wiring trench 220t. The second upper wiring trench 220t may pass through the first etching stop film 155. The second upper wiring trench 220t may expose the second lower wiring structure 120.

The second upper wiring trench 220t includes a second upper wiring line trench 220L_t. The second upper wiring line trench 220L_t may extend in one direction, for example, in the second direction D2. The second upper wiring trench 220t does not include the upper via trench 210V_t included in the first upper wiring trench (210t of FIGS. 2 and 3).

The side wall of the second upper wiring trench 220t may be a side wall of the second upper wiring line trench 220L_t, and the bottom face of the second upper wiring trench 220t may be a bottom face of the second upper wiring line trench 220L_t. The side wall of the second upper wiring line trench 220L_t may be defined by the second interlayer insulating film 160 and the first etching stop film 155. The bottom face of the second upper wiring line trench 220L_t may be defined by the second lower wiring structure 120 and the first interlayer insulating film 150.

The second upper wiring structure 220 may be disposed inside the second upper wiring trench 220t. The second upper wiring structure 220 is disposed on the second lower wiring structure 120. The second upper wiring structure 220 is connected to the second lower wiring structure 120. The second upper wiring structure 220 is in contact with the second lower wiring structure 120 and the first interlayer insulating film 150.

The second upper wiring structure 220 includes a second upper wiring line 220L. The second upper wiring structure 220 does not include the upper via 210V included in the first upper wiring structure (210 of FIGS. 1 to 3).

The second upper wiring line 220L is disposed inside the second upper wiring line trench 220L_t. The second upper wiring line 220L is in contact with the second lower wiring structure 120. The second upper wiring line 220L may be directly connected to the second lower wiring structure 120.

The second upper wiring structure 220 includes a second upper barrier structure 221ST and a second upper filling film 223. The second upper filling film 223 is disposed on the second upper barrier structure 221ST.

The second upper barrier structure 221ST includes a second upper barrier film 221 and a second upper liner film 222. The second upper barrier structure 221ST may extend along the side walls and bottom face of the second upper wiring trench 220t.

The second upper barrier film 221 extends along side walls of the second upper wiring trench 220t. The second upper barrier film 221 extends along a part or portion of the bottom face of the second upper wiring trench 220t. The second upper barrier film 221 does not extend along the portion of the bottom face of the second upper wiring trench 220t defined by the second lower wiring structure 120. The second upper barrier film 221 does not extend along the upper face 120US of the second lower wiring structure 120. That is, a portion or entirety of the interface (e.g., 120US) between the second lower wiring structure 120 and the second upper wiring structure 220 is free of the second upper barrier film 221.

The second upper barrier film 221 is in contact with the second interlayer insulating film 160. The second upper barrier film 221 is in contact with the first interlayer insulating film 150 that defines the bottom face of the second upper wiring trench 220t.

The second upper barrier film 221 may not be in contact with the second lower wiring structure 120. The second upper barrier film 211 may not be in contact with the upper face 120US of the second lower wiring structure. In contrast to the shown example, the second upper barrier film 211 may be in contact with the upper face 120US of the second lower wiring structure at the boundary portion between the second lower wiring structure 120 and the first interlayer insulating film 150. In such a case, the second upper barrier film 221 does not include a portion extending along the upper face 120US (e.g., does not extend along a central portion of the interface 120US) of the second lower wiring structure 120.

The description of the materials included in the second upper barrier film 221 may be the same as the description of the materials included in the first upper barrier film (211 of FIGS. 2 to 4).

The second upper liner film 222 is disposed on the second upper barrier film 22. The second upper liner film 222 is disposed between the second upper barrier film 221 and the second upper filling film 223. For example, the second upper liner film 222 may be in contact with the second upper barrier film 221. The second upper liner film 222 extends along side walls and the bottom face of the second upper wiring trench 220t.

The second upper liner film 222 is in contact with the second lower wiring structure 120. The second upper liner film 222 is in contact with the upper face 120US of the second lower wiring structure. The second upper liner film 222 extends along the upper face 120US of the second lower wiring structure.

The description of the materials included in the second upper liner film 222 may be the same as the description of the materials included in the second upper liner film (212 of FIGS. 2 to 4). In contrast to the shown example, the second upper liner film 222 may include a plurality of conductive films as described in FIGS. 6 to 8.

A second upper barrier structure 221 ST disposed on the side walls of the second upper wiring trench 220t includes a two-dimensional material. A part of the second upper barrier structure 221ST disposed on the bottom face of the second upper wiring trench 220t does not include (i.e., is free of) the two-dimensional material.

In FIGS. 15 and 17, the second upper liner film 222 may include a first portion 222_P1 (e.g., a central portion) that is in contact with the second lower wiring structure 120, and a second portion 222 _P2 (e.g., an edge portion) that is not in contact with the second lower wiring structure 120. In the semiconductor device according to some embodiments, the first portion 222_P1 of the second upper liner film may extend along a part of the bottom face of the second upper wiring trench 220t. The second portion 222_P2 of the second upper liner film may extend along the rest of the bottom face of the second upper wiring trench 220t and the side walls of the second upper wiring trench 220t.

The second upper barrier film 221 does not extend along the first portion 222_P1 of the second upper liner film. The second upper barrier film 221 is not disposed along the boundary or interface between the first portion 222_P1 of the second upper liner film and the second lower wiring structure 120. The second upper barrier film 221 may extend along the second portion 222_P2 of the second upper liner film.

The second upper filling film 223 is disposed on the second upper liner film 222. The second upper filling film 223 may be in contact with the second upper liner film 222. The second upper filling film 223 may fill the rest of the second upper wiring trench 220t.

The second upper liner film 222 is disposed between the second upper filling film 223 and the second lower wiring structure 120. The second upper filling film 223 may not be in direct contact with the second lower wiring structure 120.

The description of the materials included in the second upper filling film 223 may be the same as the description of the materials included in the first upper filling film (213 of FIGS. 2 to 4).

FIG. 18 is a diagram for explaining a semiconductor device according to some embodiments.

For reference, FIG. 18 exemplarily shows a configuration taken along a first gate electrode GE. In addition, in FIG. 18, the first gate electrode GE may extend in the first direction D1 as described in FIGS. 1 to 17, or may extend in the second direction D2. When the first gate electrode GE extends in the second direction D2, the first fin-like pattern AF1 extends in the first direction D1 intersecting the first gate electrode GE.

Referring to FIG. 18, the semiconductor device according to some embodiments may include a transistor TR disposed between the substrate 10 and the first lower wiring structure 110.

The substrate 10 may be a silicon substrate or silicon-on-insulator (SOI). In contrast, the substrate 10 may include, but is not limited to, silicon germanium, silicon germanium on insulator (SGOI), indium antimonide, lead telluride, indium arsenide, indium phosphide, gallium arsenide or gallium antimonide.

The transistor TR may include a first fin-like pattern AF1, a first gate electrode GE on the first fin-like pattern AF1, and a first gate insulating film GI between the first fin-like pattern AF1 and the first gate electrode GE.

Although not shown, the transistor TR may include source/drain patterns disposed on both or opposing sides of the first gate electrode GE.

The first fin-like pattern AF1 may protrude from the substrate 10. The first fin-like pattern AF1 may extend longitudinally in one direction. The first fin-like pattern AF1 may be a part of the substrate 10, and may include an epitaxial layer grown from the substrate 10. The first fin-like pattern AF1 may include, for example, silicon or germanium which are elemental semiconductor materials. Also, the first fin-like pattern AF1 may include a compound semiconductor, and may include, for example, a group IV-IV compound semiconductor or a group III-V compound semiconductor.

The group IV-IV compound semiconductor may include, for example, a binary compound or a ternary compound including at least two or more of carbon (C), silicon (Si), germanium (Ge) and tin (Sn), or a compound obtained by doping these elements with a group IV element. The group III-V compound semiconductor may be, for example, at least one of a binary compound, a ternary compound or a quaternary compound formed by combining at least one of aluminum (Al), gallium (Ga) and indium (In) as a group III element with one of phosphorus (P), arsenic (As) and antimony (Sb) as a group V element.

A field insulating film 15 may be formed on the substrate 10. The field insulating film 15 may be formed on a part of side walls of the first fin-like pattern AF1. The first fin-like pattern AF1 may protrude above the upper face of the field insulating film 15. The field insulating film 15 may include, for example, an oxide film, a nitride film, an oxynitride film or a combination thereof.

The first gate electrode GE may be disposed on the first fin-like pattern AF1. The first gate electrode GE may extend in another direction intersecting one direction in which the first fin-like pattern AF1 extends. The first gate electrode GE may intersect the first fin-like pattern AF1.

The first gate electrode GE may include, for example, at least one of metal, conductive metal nitride, conductive metal carbonitride, conductive metal carbide, metal silicide, doped semiconductor material, conductive metal oxynitride, and conductive metal oxide.

The first gate insulating film GI may be disposed between the first gate electrode GE and the first fin-like pattern AF 1, and between the first gate electrode GE and the field insulating film 15. The first gate insulating film GI may include, for example, silicon oxide, silicon oxynitride, silicon nitride or a high dielectric constant material having a dielectric constant greater than that of silicon oxide. The high dielectric constant material may include, for example, at least one of boron nitride, metal oxide, and metal silicon oxide.

The semiconductor device according to some embodiments may include a NC (Negative Capacitance) FET that uses a negative capacitor. For example, the first gate insulating film GI may include a ferroelectric material film having ferroelectric properties, and a paraelectric material film having paraelectric properties.

The ferroelectric material film may have a negative capacitance, and the paraelectric material film may have a positive capacitance. For example, if two or more capacitors are connected in series and the capacitance of each capacitor has a positive value, the overall capacitances decrease from the capacitance of each of the individual capacitors. On the other hand, if at least one of two or more capacitors connected in series has a negative value, the overall capacitances may be greater than an absolute value of each of the individual capacitances, while having a positive value.

When the ferroelectric material film having the negative capacitance and the paraelectric material film having the positive capacitance are connected in series, the overall capacitance values of the ferroelectric material film and the paraelectric material film connected in series may increase. By the use of the increased overall capacitance value, a transistor including the ferroelectric material film may have a subthreshold swing (SS) under 60 mV/decade at a room temperature.

The ferroelectric material film may have ferroelectric properties. The ferroelectric material film may include, for example, at least one of hafnium oxide, hafnium zirconium oxide, barium strontium titanium oxide, barium titanium oxide, and lead zirconium titanium oxide. Here, as an example, the hafnium zirconium oxide may be a material obtained by doping hafnium oxide with zirconium (Zr). As another example, the hafnium zirconium oxide may be a compound of hafnium (Hf), zirconium (Zr), and oxygen (O).

The ferroelectric material film may be doped with a dopant. For example, the dopant may include at least one of aluminum (Al), titanium (Ti), niobium (Nb), lanthanum (La), yttrium (Y), magnesium (Mg), silicon (Si), calcium (Ca), cerium (Ce), dysprosium (Dy), erbium (Er), gadolinium (Gd), germanium (Ge), scandium (Sc), strontium (Sr), and tin (Sn). The type of dopant included in the ferroelectric material film may vary, depending on which type of ferroelectric material is included in the ferroelectric material film.

When the ferroelectric material film includes hafnium oxide, the dopant included in the ferroelectric material film may include, for example, at least one of gadolinium (Gd), silicon (Si), zirconium (Zr), aluminum (Al), and yttrium (Y).

When the dopant is aluminum (Al), the ferroelectric material film may include 3 to 8 at% (atomic %) aluminum. Here, a ratio of the dopant may be a ratio of aluminum to the sum of hafnium and aluminum.

When the dopant is silicon (Si), the ferroelectric material film may include 2 to 10 at% silicon. When the dopant is yttrium (Y), the ferroelectric material film may include 2 to 10 at% yttrium. When the dopant is gadolinium (Gd), the ferroelectric material film may include 1 to 7 at% gadolinium. When the dopant is zirconium (Zr), the ferroelectric material film may include 50 to 80 at% zirconium.

The paraelectric material film may have the paraelectric properties. The paraelectric material film may include at least one of, for example, a silicon oxide and a metal oxide having a high dielectric constant. The metal oxide included in the paraelectric material film may include, for example, but not limited to, at least one of hafnium oxide, zirconium oxide, and aluminum oxide.

The ferroelectric material film and the paraelectric material film may include the same material. The ferroelectric material film has the ferroelectric properties, but the paraelectric material film may not have the ferroelectric properties. For example, when the ferroelectric material film and the paraelectric material film include hafnium oxide, a crystal structure of hafnium oxide included in the ferroelectric material film differs from a crystal structure of hafnium oxide included in the paraelectric material film.

The ferroelectric material film may have a thickness having the ferroelectric properties. A thickness of the ferroelectric material film may be, for example, but not limited to, 0.5 to 10 nm. Since a critical thickness that exhibits the ferroelectric properties may vary for each ferroelectric material, the thickness of the ferroelectric material film may vary depending on the ferroelectric material.

As an example, the first gate insulating film GI may include a single ferroelectric material film. As another example, the first gate insulating film GI may each include a plurality of ferroelectric material films spaced apart from each other. The first gate insulating film GI may have a stacked film structure in which the plurality of ferroelectric material films and the plurality of paraelectric material films are alternately stacked.

A gate capping pattern GE_CAP may be disposed on the first gate electrode GE. The gate capping pattern GE_CAP may not be disposed on the first gate electrode GE in some embodiments, in contrast to the shown example.

The first lower wiring structure 110 may be disposed on the first gate electrode GE. Although the first lower wiring structure 110 is shown as not being connected to the first gate electrode GE, the embodiment is not limited thereto. One of the first lower wiring structures 110 may be connected to the first gate electrode GE. The first upper wiring structure 210 is disposed on the first lower wiring structure 110.

Descriptions of the first lower wiring structure 110 and the first upper wiring structure 210 are substantially the same as those described using FIGS. 1 to 13, and therefore, will not be provided below.

In contrast to the example shown in FIG. 18, the second lower wiring structure 120 and the second upper wiring structure 220 as described using FIGS. 14 to 17 may be disposed on the substrate 10 in place of the first lower wiring structure 110 and the first upper wiring structure 210.

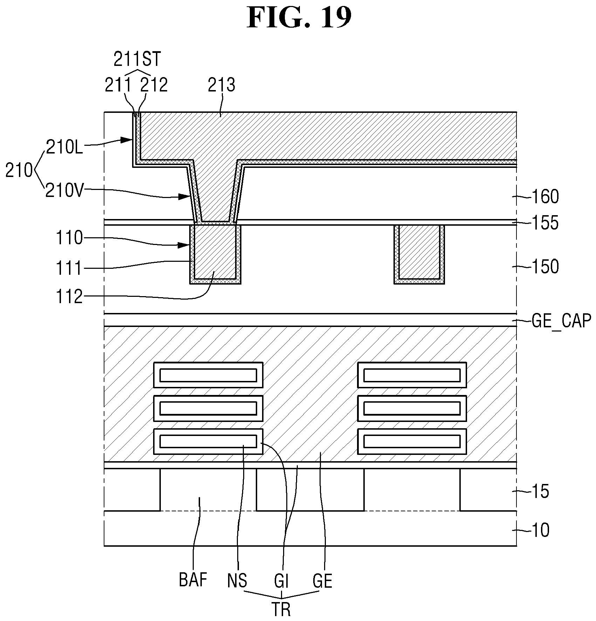

FIG. 19 is a diagram for explaining a semiconductor device according to some embodiments. For convenience of explanation, the explanation will focus on points different from those explained using FIG. 18.

Referring to FIG. 19, in the semiconductor device according to some embodiments, a transistor TR may include a nanosheet NS, a first gate electrode GE that wraps or extends around the nanosheet NS, and a first gate insulating film GI between the nanosheet NS and the first gate electrodes GE.

The nanosheet NS may be disposed on the lower fin-like pattern BAF. The nanosheet NS may be spaced apart from the lower fin-like pattern BAF in a third direction (D3 of FIG. 2). The transistor TR is shown to include three nanosheets NS spaced apart in the third direction D3, but is not limited thereto. Needless to say, the number of nanosheets NS disposed on the lower fin-like pattern BAF in the third direction D3 may be more than three or less than three.

The lower fin-like pattern BAF and the nanosheet NS may each include, for example, silicon or germanium which are elemental semiconductor materials. The lower fin-like pattern BAF and the nanosheet NS may each include may include a compound semiconductor, and may include, for example, a group IV-IV compound semiconductor or a group III-V compound semiconductor. The lower fin-like pattern BAF and the nanosheet NS may include the same material or may include different materials from each other.

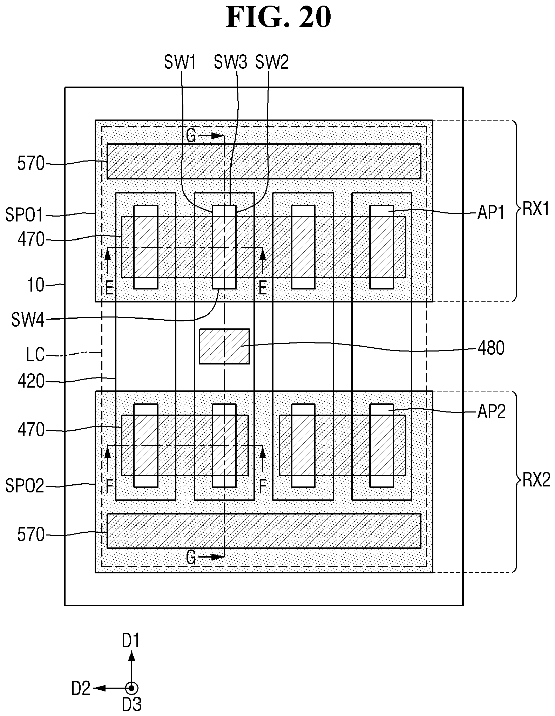

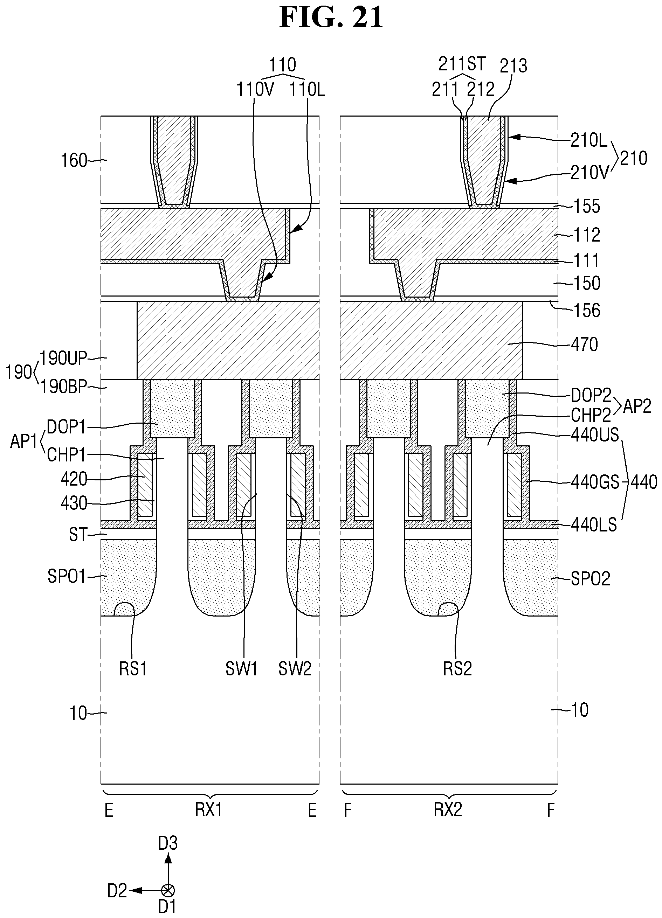

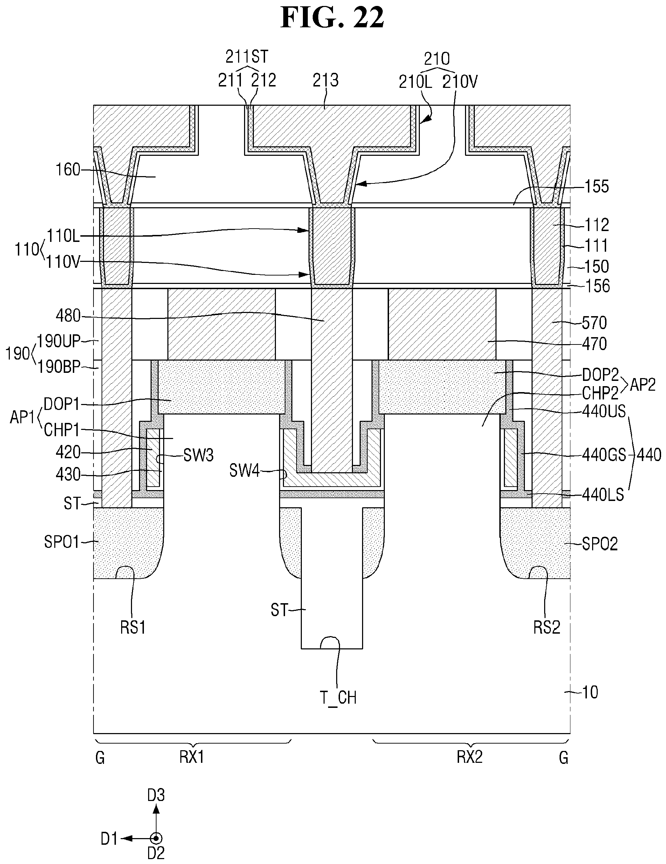

FIGS. 20 to 22 are diagrams for explaining a semiconductor device according to some embodiments. For reference, FIG. 20 is a plan view for explaining the semiconductor device according to some embodiments. FIG. 21 is a cross-sectional view taken along E-E and F-F of FIG. 20. FIG. 22 is a cross-sectional view taken along G-G of FIG. 20.

Referring to FIGS. 20 to 22, a logic cell LC may be provided on the substrate 10. The logic cell LC may refer to a logic element (e.g., an inverter, a flip-flop, etc.) that performs specific functions. The logic cell LC may include vertical transistors (Vertical FET) that form a logic element, and a wiring that connects the vertical transistors.

The logic cell LC on the substrate 10 may include a first active region RX1 and a second active region RX2. For example, the first active region RX1 may be a PMOSFET region, and the second active region RX2 may be an NMOSFET region. The first and second active regions RX1 and RX2 may be defined by the trench T_CH formed in the upper portion of the substrate 10. The first and second active regions RX1 and RX2 may be spaced apart from each other in the first direction D1.

A first lower epitaxial pattern SPO1 may be provided on the first active region RX1, and a second lower epitaxial pattern SPO2 may be provided on the second active region RX2. From a planar viewpoint, the first lower epitaxial pattern SPO1 may overlap the first active region RX1, and the second lower epitaxial pattern SPO2 may overlap the second active region RX2. The first and second lower epitaxial patterns SPO1 and SPO2 may be epitaxial patterns formed by a selective epitaxial growth process. The first lower epitaxial pattern SPO1 may be provided in the first recess region RS1 of the substrate 10, and the second lower epitaxial pattern SPO2 may be provided in the second recess region RS2 of the substrate 10.

The first active patterns AP1 may be provided on the first active region RX1, and the second active patterns AP2 may be provided on the second active region RX2. Each of the first and second active patterns AP1 and AP2 may have the shape of a fin that protrudes vertically. From a planar viewpoint, each of the first and second active patterns AP 1 and AP2 may have a bar shape extending in the first direction D2. The first active patterns AP1 may be arranged and spaced apart along the second direction D2, and the second active patterns AP2 may be arranged and spaced apart along the second direction D2.

Each first active pattern AP1 may include a first channel pattern CHP1 protruding vertically from the first lower epitaxial pattern SPO1, and a first upper epitaxial pattern DOP1 on the first channel pattern CHP1. Each second active pattern AP2 may include a second channel pattern CHP2 protruding vertically from the second lower epitaxial pattern SPO2, and a second upper epitaxial pattern DOP2 on the second channel pattern CHP2.

The element isolation film ST may be provided on the substrate 10 to fill the trench T_CH. The element isolation film ST may cover upper faces of the first and second lower epitaxial patterns SPO1 and SPO2. The first and second active patterns AP1 and AP2 may protrude vertically above the element isolation film ST.

A plurality of second gate electrodes 420 extending parallel to each other in the first direction D1 may be provided on the element isolation film ST. The second gate electrodes 420 may be arranged and spaced apart along the second direction D2. The second gate electrode 420 may surround the first channel pattern CHP1 of the first active pattern AP1, and may surround the second channel pattern CHP2 of the second active pattern AP2. For example, the first channel pattern CHP1 of the first active pattern AP 1 may have first to fourth side walls SW1 to SW4. The first and second side walls SW1 and SW2 may be opposite to each other in the second direction D2, and the third and fourth side walls SW3 and SW4 may be opposite to each other in the first direction D1. The second gate electrode 420 may be provided on the first to fourth side walls SW1 to SW4. In other words, the second gate electrode 420 may surround the first to fourth side walls SW1 to SW4.

A second gate insulating film 430 may be interposed between the second gate electrode 420 and each of the first and second channel patterns CHP1 and CHP2. The second gate insulating film 430 may cover the bottom face of the second gate electrode 420 and inner side wall of the second gate electrode 420. For example, the second gate insulating film 430 may directly cover the first to fourth side walls SW1 to SW4 of the first active pattern AP1.

The first and second upper epitaxial patterns DOP1 and DOP2 may protrude vertically above the second gate electrode 420. The upper face of the second gate electrode 420 may be lower than the bottom faces of each of the first and second upper epitaxial patterns DOP1 and DOP2. In other words, each of the first and second active patterns AP 1 and AP2 may have a structure that vertically protrudes from the substrate 10 and penetrates the second gate electrode 420.

The semiconductor element according to the present embodiment may include vertical transistors in which carriers move in the third direction D3. For example, when a voltage is applied to the second gate electrode 420 and the transistor is turned "on", the carriers may move from the lower epitaxial patterns SPO1 and SPO2 to the upper epitaxial patterns DOP1 and DOP2 through the channel patterns CHP1 and CHP2. In the semiconductor device according to some embodiments, the second gate electrode 420 may completely surround side walls SW1 to SW4 of the channel patterns CHP1 and CHP2. The transistor according to the present disclosure may be a three-dimensional field effect transistor (e.g., VFET) having a gate all-around structure. Since the gate surrounds the channel, the semiconductor element according to the disclosure may have excellent electrical properties.

A spacer 440 that covers the second gate electrodes 420 and the first and second active patterns AP1 and AP2 may be provided on the element isolation film ST. The spacer 440 may include a silicon nitride film or a silicon oxynitride film. The spacer 440 may include a lower spacer 440LS, an upper spacer 440US, and a gate spacer 440GS between the lower and upper spacers 440LS and 440US.

The lower spacer 440LS may directly cover the upper face of the element isolation film ST. The second gate electrodes 420 may be spaced apart from the element isolation film ST in the third direction D3 by the lower spacer 440LS. The gate spacer 440GS may cover the upper faces and the outer side walls of each of the second gate electrodes 420. The upper spacer 440US may cover the first and second upper epitaxial patterns DOP1 and DOP2. However, the upper spacer US does not cover the upper faces of the first and second upper epitaxial patterns DOP1 and DOP2, and may expose the upper faces of the first and second upper epitaxial patterns DOP1 and DOP2.

A first portion 190BP of the first lower interlayer insulating film 190 may be provided on the spacer 440. An upper face of the first portion 190BP of the first lower interlayer insulating film 190 may be substantially coplanar with the upper faces of the first and second upper epitaxial patterns DOP1 and DOP2. A second portion 190UP of the first lower interlayer insulating film 190 and first and second interlayer insulating films 150 and 160 may be sequentially stacked on the first portion 190BP of the first lower interlayer insulating film 190. The first portion 190BP and the second portion 190UP may be included in the first lower interlayer insulating film 190. The second portion 190UP of the first lower interlayer insulating film 190 may cover the upper faces of the first and second upper epitaxial patterns DOP1 and DOP2.

At least one first source/drain contact 470 which penetrates the second portion 190UP of the first lower interlayer insulating film and is connected to the first and second upper epitaxial patterns DOP1 and DOP2 may be provided. At least one second source/drain contact 570 which sequentially penetrates the first lower interlayer insulating film 190, the lower spacer 440LS and the element isolation film ST and is connected to the first and second lower epitaxial patterns SPO1 and SPO2 may be provided. A gate contact 480 which sequentially penetrates the second portion 190UP of the first lower interlayer insulating film, the first portion 190BP of the first lower interlayer insulating film, and the gate spacer 440GS and is connected to the second gate electrode 420 may be provided.

A second etching stop film 156 may be additionally disposed between the second portion 190UP of the first lower interlayer insulating film and the first interlayer insulating film 150. A first etching stop film 155 may be disposed between the first interlayer insulating film 150 and the second interlayer insulating film 160.

The first lower wiring structure 110 may be provided in the first interlayer insulating film 150. The first lower wiring structure 110 may include a lower via 110V and a lower wiring line 110L. The description of the lower via 110V and the lower wiring line 110L may be similar to the description of the upper via 210V and the first upper wiring line 210L. However, the film structure of the first lower wiring structure 110 may be different from or the same as the film structure of the first upper wiring structure 210.

The first lower wiring structure 110 may be connected to the first source/drain contact 470, the second source/drain contact 570, and the gate contact 480. The upper wiring structure 210 may be provided in the second interlayer insulating film 160.

An additional wiring structure similar to the first upper wiring structure 210 may be further disposed, for example, between the first source/drain contact 470 and the first lower wiring structure 110, in contrast to the shown example.

A detailed description of the first upper wiring structure 210 may be substantially the same as that described using FIGS. 1 to 13. In contrast to that shown in FIGS. 21 and 22, the second lower wiring structure 120 and the second upper wiring structure 220 may be disposed on the substrate 10 as described using FIGS. 14 to 17.

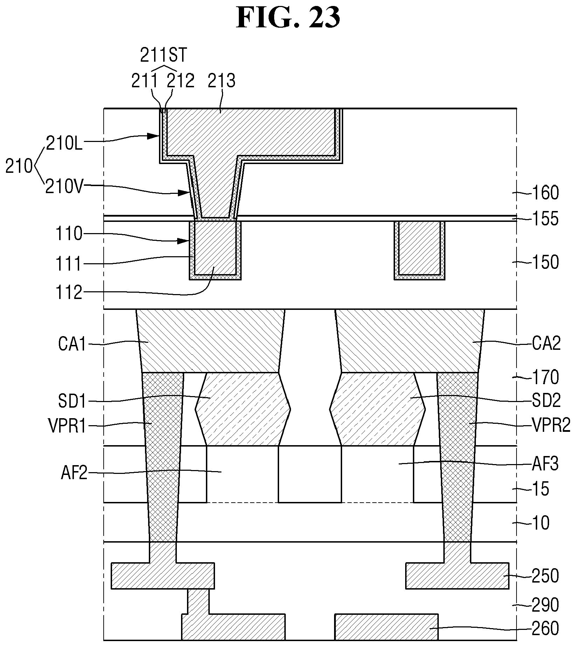

FIG. 23 is a diagram for explaining a semiconductor device according to some embodiments.

Referring to FIG. 23, the semiconductor device according to some embodiments may include a first source/drain pattern SD1, a second source/drain pattern SD2, a third source/drain contact CA1, a fourth source/drain contact CA2, a first contact connecting via VPR1, a second contact connecting via VPR2, and back wiring structures 250 and 260.

The second fin-like pattern AF2 and the third fin-like pattern AF3 may protrude from the substrate 10. For example, the second fin-like pattern AF2 and the third fin-like pattern AF3 may protrude from the upper face of the substrate 10. The second fin-like pattern AF2 and the third fin-like pattern AF3 may be spaced apart from each other. Each of the second fin-like pattern AF2 and the third fin-like pattern AF3 may include at least one of a group IV-IV compound semiconductor or a group III-V compound semiconductor which is an elemental semiconductor material.

The field insulating film 15 may be disposed on side walls of the second fin-like pattern AF2 and the third fin-like pattern AF3. The field insulating film 15 may separate the second fin-like pattern AF2 and the third fin-like pattern AF3.

The first source/drain pattern SD1, the second source/drain pattern SD2, the third source/drain contact CA1 and the fourth source/drain contact CA2 may be disposed on the upper face of the substrate 10.

The first source/drain pattern SD1 may be disposed on the second fin-like pattern AF2. The first source/drain pattern SD1 may be connected to the second fin-like pattern AF2.

The second source/drain pattern SD2 may be disposed on the third fin-like pattern AF3. The second source/drain pattern SD2 may be connected to the third fin-like pattern AF3. The second source/drain pattern SD2 is separated from the first source/drain pattern SD1. The second source/drain pattern SD2 is not connected to the first source/drain pattern SD1.

Although not shown, as an example, the first source/drain pattern SD1 and the second source/drain pattern SD2 may be connected to a channel region having a fin-like shape as in the first fin-like pattern AF1 shown in FIG. 18. As another example, the first source/drain pattern SD1 and the second source/drain pattern SD2 may be connected to a channel region having the same shaped as the nanosheet NS shown in FIG. 19. In such a case, the second fin-like pattern AF2 and the third fin-like pattern AF3 may each be similar to the lower fin-like pattern BAF shown in FIG. 19.

The first source/drain pattern SD1 and the second source/drain pattern SD2 include a semiconductor material. The first source/drain pattern SD1 and the second source/drain pattern SD2 may be semiconductor patterns formed by an epitaxial process.

A third source/drain contact CA1 may be disposed on the first source/drain pattern SD1. The third source/drain contact CA1 is connected to the first source/drain pattern SD1. For example, the third source/drain contact CA1 is electrically connected to the first source/drain pattern SD1.

A fourth source/drain contact CA2 may be disposed on the second source/drain pattern SD2. The fourth source/drain contact CA2 is connected to the second source/drain pattern SD2. For example, the fourth source/drain contact CA2 is electrically connected to the second source/drain pattern SD2. The third source/drain contact CA1 and the fourth source/drain contact CA2 are separated from each other.

A second lower interlayer insulating film 170 may be disposed on the field insulating film 15. The second lower interlayer insulating film 170 may be disposed around the first source/drain pattern SD1, the second source/drain pattern SD2, the third source/drain contact CA1 and the fourth source/drain contact CA2. The second lower interlayer insulating film 170 separates the third source/drain contact CA1 and the fourth source/drain contact CA2.

The back wiring structures 250 and 260 may be disposed on the lower face of the substrate 10. The lower face of the substrate 10 is opposite to the upper face of the substrate 10 in the third direction (D3 of FIG. 2). The back wiring structures 250 and 260 may include a first back wiring structure 250 and a second back wiring structure 260.

The first back wiring structure 250 may be connected to the first source/drain pattern SD1 and the second source/drain pattern SD2. For example, the first back wiring structure 250 may be electrically connected to the first source/drain pattern SD1 and the second source/drain pattern SD2.

The second back wiring structure 260 may be disposed on the first back wiring structure 250. The second back wiring structure 260 may be connected to the first back wiring structure 250.

Although a plurality of back wiring structures disposed at a plurality of metal levels are shown as being disposed on the lower face of the substrate 10, this is only for convenience of explanation, and the embodiment is not limited thereto. In contrast to the shown example, only a back wiring structure disposed at one metal level may be disposed on the lower face of the substrate 10. That is, only the first back wiring structure 250 may be disposed on the lower face of the substrate 10.

Although the first back wiring structure 250 and the second back wiring structure 260 are each shown as being an integral structure in which the wiring line and the via is integrated, the embodiment is not limited thereto. In contrast to the shown example, at least one of the first back wiring structure 250 and the second back wiring structure 260 may have a structure in which the boundary between the wiring lines and the via is divided.

The first back wiring structure 250 is shown to include the wiring line and the via, but is not limited thereto. In contrast to the shown example, the first back wiring structure 250 may include only portions corresponding to the wiring line.

A back wiring insulating film 290 is disposed on the lower face of the substrate 10. The back wiring structures 250 and 260 are disposed in the back wiring insulating film 290.

A first contact connecting via VPR1 may be disposed between the third source/drain contact CA1 and the first back wiring structure 250. The first contact connecting via VPR1 electrically connects the third source/drain contact CA1 and the first back wiring structure 250. The first contact connecting via VPR1 passes through the field insulating film 15 and the substrate 10, and may be connected to the first back wiring structure 250.

A second contact connecting via VPR2 may be disposed between the fourth source/drain contact CA2 and the first back wiring structure 250. The second contact connecting via VPR2 electrically connects the fourth source/drain contact CA2 and the first back wiring structure 250. The second contact connecting via VPR2 passes through the field insulating film 15 and the substrate 10, and may be connected to the first back wiring structure 250.

Taking the third source/drain contact CA1 and the first contact connecting via VPR1 as an example, although the third source/drain contact CA1 is shown to cover the entire upper face of the first contact connecting via VPR1, this is only for convenience of explanation, and the embodiment is not limited thereto. In contrast to the shown example, as an example, the third source/drain contact CA1 may cover a part of the upper face of the first contact connecting via VPR1. In such a case, the rest of the upper face of the first contact connecting via VPR1 may be coplanar with the upper face of the third source/drain contact CA1. As another example, the entire upper face of the first contact connecting via VPR1 may be coplanar with the upper face of the third source/drain contact CA1. In such a case, the third source/drain contact CA1 and the first contact connecting via VPR1 may be connected by a via connecting pattern that is in contact with the upper face of the source/drain contact CA1 and the upper face of the first contact connecting via VPR1.

In contrast to the shown example, the first contact connecting via VPR1 and the second contact connecting via VPR2 may include connecting via portions and buried conductive pattern portions. The connecting via portion may be connected to the third source/drain contact CA1 and the fourth source/drain contact CA2. The buried conductive pattern portion may be connected to the back wiring structures 250 and 260.

The connecting via portion may be disposed in the second lower interlayer insulating film 170 and the field insulating film 15. The buried conductive pattern portion may be disposed in the substrate 10. As an example, the buried conductive pattern portion may have a linear shape extending longitudinally in one direction. As another example, the buried conductive pattern portion may have a contact shape, like the second lower wiring structure 120 of FIGS. 15 and 16.

The third source/drain contact CA1, the fourth source/drain contact CA2, the first contact connecting via VPR1, the second contact connecting via VPR2, and the back wiring structures 250 and 260 may each include, for example, at least one of conductive metal nitride, conductive metal carbonitride, conductive metal carbide, metal silicide, doped semiconductor material, conductive metal oxynitride, and conductive metal oxide.

Although the third source/drain contact CA1, the fourth source/drain contact CA2, the first contact connecting via VPR1, the second contact connecting via VPR2, the first back wiring structure 250, and the second back wiring structure 260 are each shown as having a single conductive film structure, like the second lower wiring structure 120 of FIGS. 15 and 16, the embodiment is not limited thereto. At least one of the third source/drain contact CA1, the fourth source/drain contact CA2, the first contact connecting via VPR1, the second contact connecting via VPR2, the first back wiring structure 250 and the second back wiring structure 260 may have multiple conductive film structures including a barrier film and a filling film.

The first lower wiring structure 110 may be disposed on the upper face of the substrate 10. The first lower wiring structure 110 may be disposed on the third source/drain contact CA1 and the fourth source/drain contact CA2. Although the first lower wiring structure 110 is shown as not being connected to the third source/drain contact CA1 and the fourth source/drain contact CA2, the embodiment is not limited thereto. The first upper wiring structure 210 is disposed on the first lower wiring structure 110.

In contrast to the shown example, a second lower wiring structure 120 and a second upper wiring structure 220 as explained using FIGS. 14 to 17 may be disposed on the upper face of the substrate 10.

In addition, in contrast to the shown example, at least one of the first back wiring structure 250 and the second back wiring structure 260 may include a barrier film formed of a two-dimensional material, like the first upper wiring structure 210.

In contrast to the shown example, the semiconductor device shown in FIG. 23 may not include the substrate 10. During the fabricating process, the substrate 10 may be removed using a grinding process or the like.

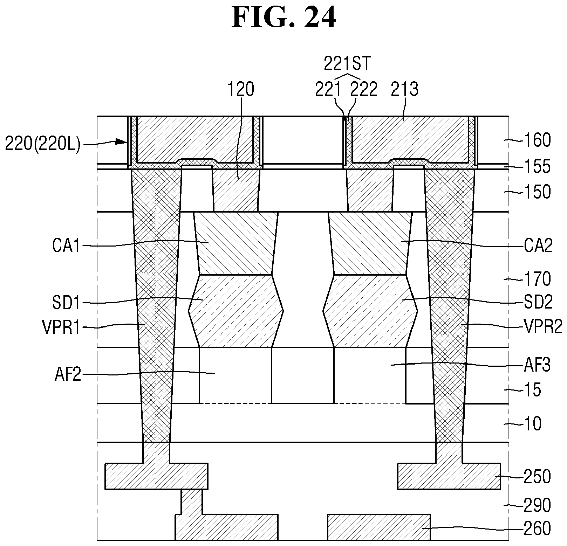

FIGS. 24 to 26 are diagrams for explaining a semiconductor device according to some embodiments, respectively. For convenience of explanation, the explanation will focus on points different from those explained using FIG. 23.

Referring to FIG. 24, in the semiconductor device according to some embodiments, the second upper wiring structure 220 and the second lower wiring structure 120 may connect the third source/drain contact CA1 and the first contact connecting via VPR1.

The second upper wiring structure 220 and the second lower wiring structure 120 may connect the fourth source/drain contact CA2 and the second contact connecting via VPR2.

The third source/drain contact CA1 and the first contact connecting via VPR1 may be electrically connected by the second upper wiring structure 220 including a barrier film formed of a two-dimensional material. The fourth source/drain contact CA2 and the second contact connecting via VPR2 may be electrically connected by the second upper wiring structure 220 including a barrier film formed of a two-dimensional material.

The second lower wiring structure 120 may be disposed between the second upper wiring structure 220 and the third source/drain contact CA1. The second lower wiring structure 120 may be disposed between the second upper wiring structure 220 and the fourth source/drain contact CA2.

A part of the first contact connecting via VPR1 and a part of the second contact connecting via VPR2 may be disposed in the first interlayer insulating film 150. The first contact connecting via VPR1 and the second contact connecting via VPR2 may be in contact with the second upper wiring structure 220, respectively.

The second lower wiring structure 120 may be further disposed between the first contact connecting via VPR1 and the second upper wiring structure 220, in contrast to the shown example. The second lower wiring structure 120 may be further disposed between the second contact connecting via VPR2 and the second upper wiring structure 220.

Descriptions of the second lower wiring structure 120 and the second upper wiring structure 220 are substantially the same as those described using FIGS. 14 to 17.

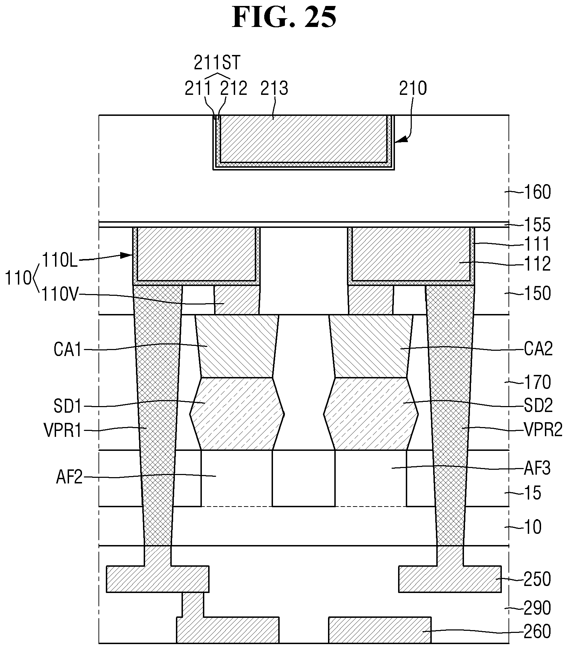

Referring to FIG. 25, in the semiconductor device according to some embodiments, the first lower wiring structure 110 may connect the third source/drain contact CA1 and the first contact connecting via VPR1.

The first lower wiring structure 110 may connect the fourth source/drain contact CA2 and the second contact connecting via VPR2.

The first lower wiring structure 110 may include a lower via 110V and a lower wiring line 110L. The lower via 110V may be disposed between the lower wiring line 110L and the third source/drain contact CA1. The lower via 110V may be disposed between the lower wiring line 110L and the fourth source/drain contact CA2.

The first contact connecting via VPR1 and the second contact connecting via VPR2 may each be in contact with the lower wiring line 110L. In contrast to the shown example, the lower via 110V may be further disposed between the first contact connecting via VPR1 and the lower wiring line 110L. The lower via 110V may be further disposed between the second contact connecting via VPR2 and the lower wiring line 110L.

The first upper wiring structure 210 may be disposed on the first lower wiring structure 110.

Although the lower via 110V and the lower wiring line 110L are shown to have different structures, the embodiment is not limited thereto. The first lower wiring structure 110 may include a lower via 110V and a lower wiring line 110L formed as an integral structure. As an example, the first lower wiring structure 110 formed as the integral structure may include a barrier film formed of a two-dimensional material, like the first upper wiring structure 210. As another example, the first lower wiring structure 110 formed as the integral structure may not include a barrier film formed of a two-dimensional material.

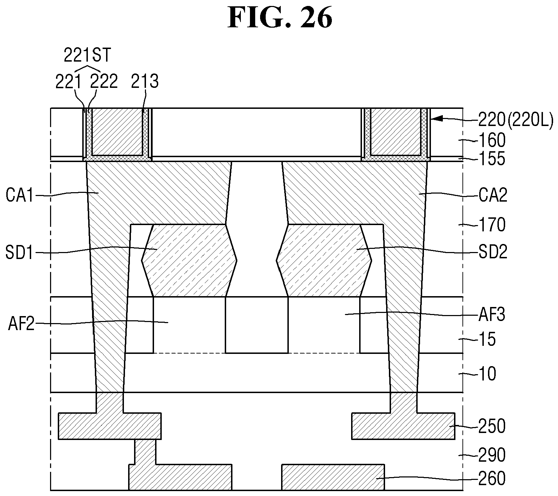

Referring to FIG. 26, in the semiconductor device according to some embodiments, the third source/drain contact CA1 and the fourth source/drain contact CA2 may each be connected to the first back wiring structure 250.

The third source/drain contact CA1 and the fourth source/drain contact CA2 may each include a contact portion connected to the first source/drain pattern SD1 and the second source/drain pattern SD2, and a via portion connected in the third direction (D3 of FIG. 2). The via portion of the third source/drain contact CA1 and the via portion of the fourth source/drain contact CA2 may penetrate the field insulating film 15. For example, the via portion of the third source/drain contact CA1 and the via portion of the fourth source/drain contact CA2 may penetrate the substrate 10.

In contrast to the shown example, additional buried conductive patterns may be disposed between the third source/drain contact CA1 and the first back wiring structure 250, and between the fourth source/drain contact CA2 and the first back wiring structure 250. For example, the additional buried conductive patterns may be disposed inside the substrate 10.

The second upper wiring structure 220 may be disposed on the third source/drain contact CA1 and the fourth source/drain contact CA2. The third source/drain contact CA1 and the fourth source/drain contact CA2 may each be in contact with the second upper wiring structure 220.

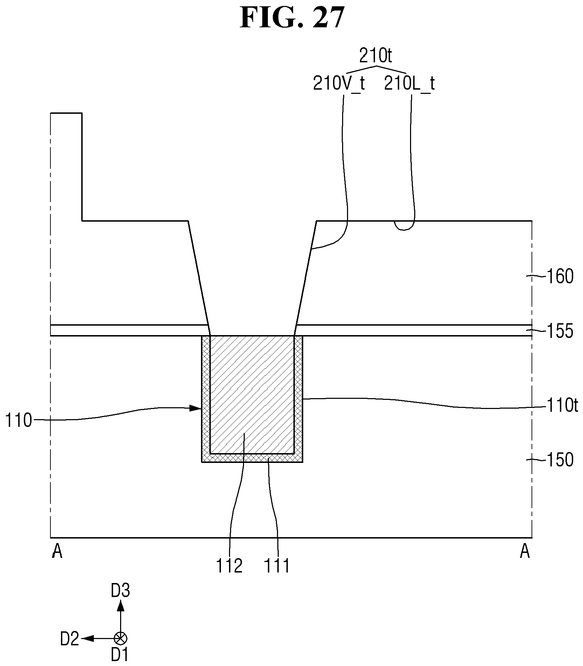

FIGS. 27 to 32 are intermediate step diagrams for describing a method for fabricating the semiconductor device according to some embodiments.

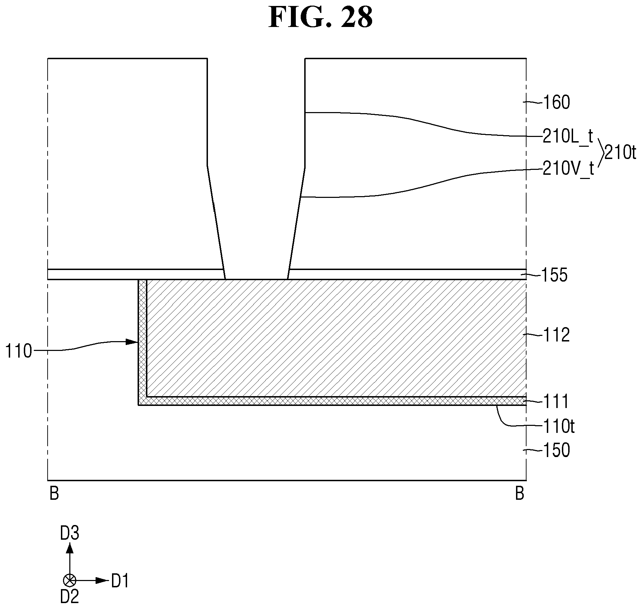

For reference, FIGS. 27 and 29 to 32 are cross-sectional views taken along A-A of FIG. 1. FIG. 28 is a cross-sectional views taken along B-B of FIG. 1

Referring to FIGS. 27 and 28, the first lower wiring structure 110 is formed in the first interlayer insulating film 150.

The first lower wiring trench 110t is formed in the first interlayer insulating film 150. The first lower wiring structure 110 is formed in the first lower wiring trench 1 10t. The first lower wiring structure 110 may include a lower barrier film 111 and a lower filling film 112.

Subsequently, a first etching stop film 155 may be formed on the first interlayer insulating film 150 and the first lower wiring structure 110.

The second interlayer insulating film 160 may be formed on the first etching stop film 155. The second interlayer insulating film 160 may include a first upper wiring trench 210t. The first upper wiring trench 210t may include an upper via trench 210V_t and a first upper wiring line trench 210L_t.

The first upper wiring trench 210t may penetrate the first etching stop film 155. The first upper wiring trench 210t may expose a part of the first lower wiring structure 110.

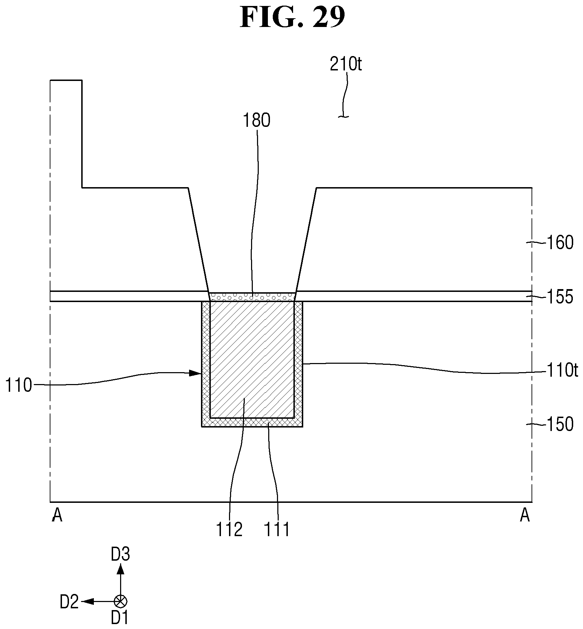

Referring to FIG. 29, a selective suppression film 180 is formed on the first lower wiring structure 110 exposed by the first upper wiring trench 210t.

The selective suppression film 180 may be formed on the conductive material. The selective suppression film 180 is not formed on the insulating material.

The selective suppression film 180 includes an organic material. The selective suppression film 180 may prevent the conductive material from being deposited on the surface on which the selective suppression film 180 is formed.

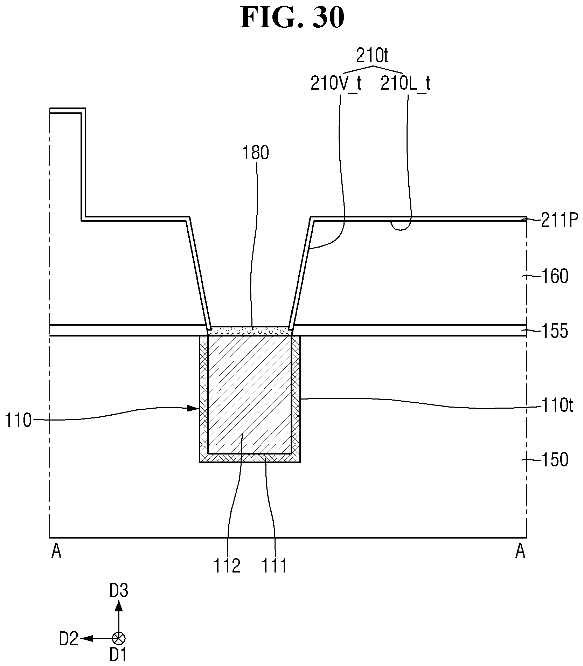

Referring to FIG. 30, the pre-upper barrier film 211P is formed along side walls of the first upper wiring trench 210t, in the state in which the selective suppression film 180 is formed. The pre-upper barrier film 211P is formed along the upper face of the second interlayer insulating film 160.

The pre-upper barrier film 211P is not formed on the first lower wiring structure 110 on which the selective suppression film 180 is formed. The pre-upper barrier film 211P may not be formed along the bottom face of the first upper wiring trench 210t.

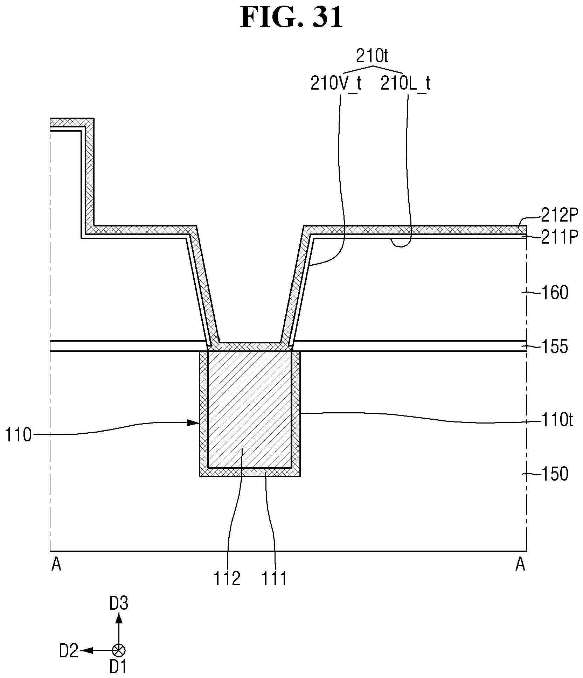

Referring to FIGS. 30 and 31, the selective suppression film 180 may be removed to expose the first lower wiring structure 110.

The selective suppression film 180 may be removed through, for example, plasma treatment, but is not limited thereto.

Subsequently, the pre-upper liner film 212P may be formed on the pre-upper barrier film 211P. The pre-upper liner film 212P may be formed along the side walls of the first upper wiring trench 210t and the bottom face of the upper wiring trench 210t. The pre-upper liner film 212P is formed along the upper face of the second interlayer insulating film 160.

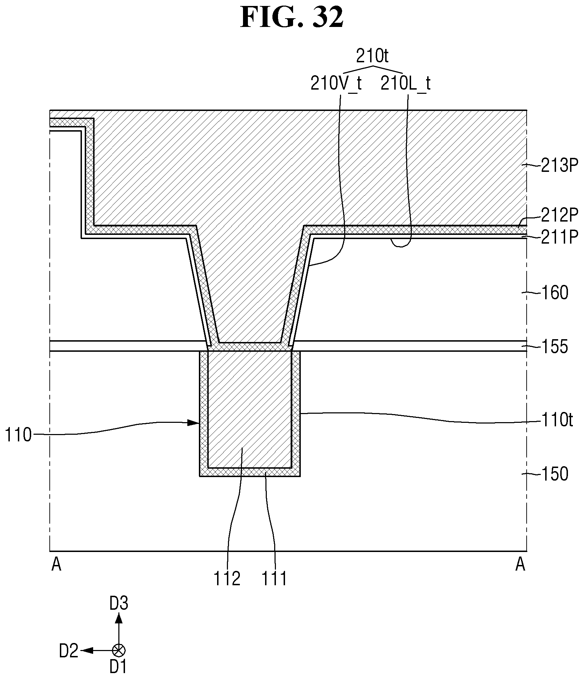

Referring to FIG. 32, the pre-upper filling film 213P may be formed on the pre-upper liner film 212P.

The pre-upper filling film 213P may fill the first upper wiring trench 210t. The pre-upper filling film 213P may cover the upper face of the second interlayer insulating film 160.

Subsequently, referring to FIG. 2, the pre-upper barrier film 211P, the pre-upper liner film 212P, and the pre-upper filling film 213P on the upper face of the second interlayer insulating film 160 may be removed. Therefore, the first upper wiring structure 210 may be formed in the first upper wiring trench 210t.

Although the embodiments of the present disclosure have been described with reference to the accompanying drawings, the present disclosure is not limited to the above embodiments and may be implemented in various different forms. Those of ordinary skill in the technical field to which the present disclosure belongs will be able to understand that the present disclosure may be implemented in other specific forms without changing the inventive concepts of the present disclosure. Therefore, it should be understood that the embodiments as described above are not restrictive but illustrative in all respects.

## Claims

1. A semiconductor device comprising:
a lower wiring structure;
an upper interlayer insulating film on the lower wiring structure and comprising an upper wiring trench therein; and
an upper wiring structure in the upper wiring trench and comprising an upper barrier structure and an upper filling film on the upper barrier structure,
wherein the upper barrier structure includes side wall portions extending along side walls of the upper wiring trench, and a bottom portion extending along a bottom surface of the upper wiring trench,
wherein the side wall portions of the upper barrier structure include a two-dimensional material, and
wherein the bottom portion of the upper barrier structure is free of the two-dimensional material.

2. The semiconductor device of claim 1,
wherein the upper barrier structure comprises an upper barrier film and an upper liner film between the upper barrier film and the upper filling film, wherein the upper barrier film is in contact with the upper interlayer insulating film, and comprises the two-dimensional material.

3. The semiconductor device of claim 2,
wherein the upper liner film comprises tantalum nitride and/or tantalum nitride doped with ruthenium.

4. The semiconductor device of claim 2,
wherein the upper liner film comprises cobalt and/or ruthenium-cobalt.

5. The semiconductor device of claim 2,
wherein the upper liner film comprises a first sub-upper liner film, and a second sub-upper liner film between the first sub-upper liner film and the upper filling film.

6. The semiconductor device of claim 5,
wherein the first sub-upper liner film and the second sub-upper liner film each extend along the side walls and the bottom surface of the upper wiring trench.

7. The semiconductor device of claim 5,
wherein the first sub-upper liner film comprises tantalum nitride and/or tantalum nitride doped with ruthenium, and
the second sub-upper liner film comprises cobalt and/or ruthenium-cobalt.

8. The semiconductor device of claim 1,
wherein the upper barrier structure comprises an upper barrier film and an upper liner film between the upper barrier film and the upper filling film,
wherein the upper barrier film is free of direct contact with the lower wiring structure,
and
the upper liner film is in contact with the upper filling film and the lower wiring structure along an interface between the lower wiring structure and the upper wiring structure.

9. The semiconductor device of claim 1,
wherein the upper barrier structure includes an upper barrier film and an upper liner film between the upper barrier film and the upper filling film,
wherein the upper barrier film is in contact with the lower wiring structure at edge portions of an interface between the lower wiring structure and the upper wiring structure, and
wherein a central portion of the interface between the lower wiring structure and the upper wiring structure is free of the upper barrier film.

10. The semiconductor device of claim 1,
wherein the two-dimensional material comprises tantalum sulfide.

11. A semiconductor device comprising:
a lower wiring structure;
an upper interlayer insulating film on the lower wiring structure and comprising an upper wiring trench therein; and
an upper wiring structure in the upper wiring trench and comprising an upper barrier film and an upper filling film on the upper barrier film,
wherein the upper barrier film extends along side walls of the upper wiring trench and does not extend along at least a portion of an interface between the upper wiring structure and the lower wiring structure, and
the upper barrier film comprises a two-dimensional material.

12. The semiconductor device of claim 11, further comprising:
an upper liner film between the upper barrier film and the upper filling film,
wherein the upper liner film extends along the side walls and a bottom surface of the upper wiring trench.

13. The semiconductor device of claim 12,
wherein the upper liner film comprises tantalum nitride, tantalum nitride doped with ruthenium, cobalt, and/or ruthenium-cobalt.

14. The semiconductor device of claim 12,
wherein the upper liner film comprises a plurality of conductive films.

15. The semiconductor device of claim 11,
wherein the upper filling film is free of direct contact with the lower wiring structure.
